# EUROPÄISCHE PATENTSCHRIFT

(11) **EP 1 711 753 B1**
(45) Veröffentlichungstag und Bekanntmachung des Hinweises auf die Patenterteilung: **18.08.2010**
(21) Anmeldenummer: 05706883.5
(22) Anmeldetag: 14.01.2005
(51) Int. Cl.: F24J 2/04, E04D 3/35

(54) **VAKUUMGEDÄMMTES, MODULARES DACHSYSTEM**
VACUUM-INSULATED, MODULAR ROOF SYSTEM
SYSTEME DE TOIT MODULAIRE A ISOLATION PAR VIDE

(30) Priorität: 14.01.2004 DE 102004001875
(43) Veröffentlichungstag der Anmeldung: 18.10.2006
(73) Patentinhaber: Hake, Thomas, 59379 Selm (DE)
(72) Erfinder: Hake, Thomas, 59379 Selm (DE)
(74) Vertreter: Hoffmeister, Helmut
(86) Internationale Anmeldenummer: PCT/EP2005/000296
(87) Internationale Veröffentlichungsnummer: WO 2005/068917

(56) Entgegenhaltungen:
- WO-A-01/66864
- DE-A1- 10 225 167
- DE-A1- 10 226 188
- DE-A1- 19 847 110

## Beschreibung

Die Erfindung betrifft ein gedämmtes, modulares Dachsystem, aufweisend wenigstens ein Fertigdachmodul, das wenigstens einen Strömungskanal für ein fluidisches Mittel und tragende Strukturen umfasst, die mit einer planen, der Sonneneinstrahlrichtung abgewandten Innenschale unterlegt sind, die aus wenigstens einem umhüllten, luftevakuierten, plattenförmigen Vakuum-Isolations-Paneel besteht, das eine Thermoisolierungsschicht bildet.

Bekannt ist ein derartiges Fertigdachmodul aus DE 198 47 110 A1. Das Dokument beschreibt ein Bauelement zum Erstellen von tragenden Wänden, Decken, Böden oder Dächern, das als plattenförmiges Vakuumelement gestaltet ist und eine Umhüllung aufweist, die einen vakuumdicht abgeschlossenen und evakuierten Hohlraum umgrenzt, der mit einem mikroporösen, offenporigen Wärmedämmstoff befüllt ist. Das bekannte Bauelement ist plattenförmig als vormontiertes Verbundelement mit einem durch das Vakuumelement gebildeten Isolierteil und einer Leichtbau-Tragkonstruktion als Tragteil ausgebildet. Die Umhüllung des Vakuumelementes ist an einer ihrer äußeren Flachseiten mit einer Leichtbau-Tragkonstruktion verbunden. Alternativ kann an der der Tragkonstruktion abgewandten Flachseite des bekannten Vakuumelementes ein Sonnenkollektor mit an einer Absorberfläche angeordneten Rohrleitungen für ein Wärmeträgermedium angebracht sein. Der Sonnenkollektor kann eine durch eine Glas- oder Vakuumglasscheibe gebildete Abdeckung aufweisen, die parallel zur Erstreckungsebene des Vakuumelements angeordnet ist und von diesem durch einen Freiraum beabstandet ist.

Durch eine raumseitige Vorsatzschale des bekannten Bauelementes kann dieses - ohne es selbst zu beschädigen befestigt werden.

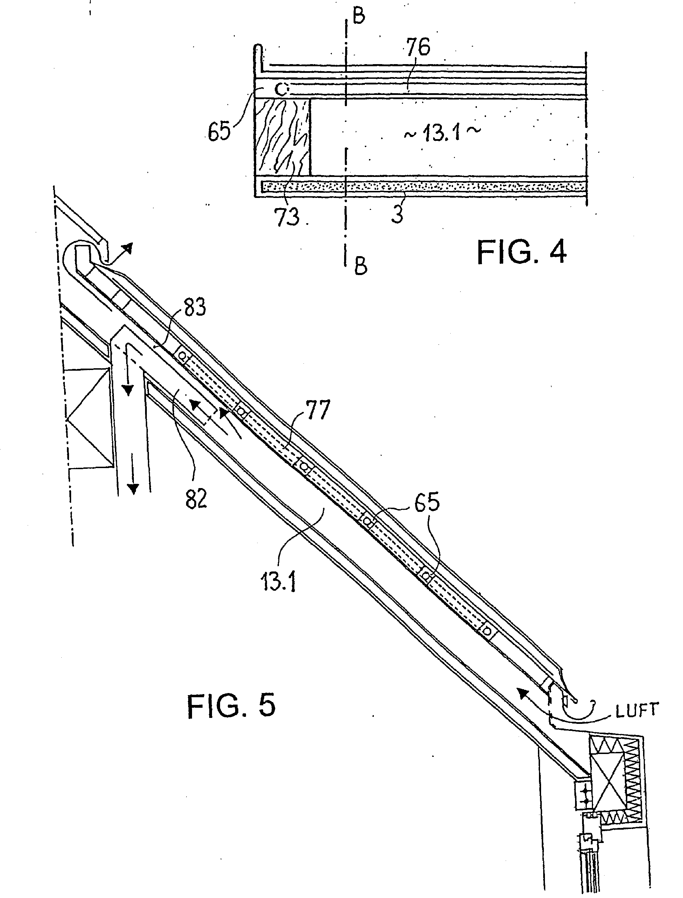

Ein wärmegedämmter Fertigdachmodul ist ferner aus der DE 19644284 Al bekannt. Die Thermoisolierung des Fertigdachmoduls besteht aus einem Beplankungs- und Dämmmaterial und/oder aus Dämmmaterial, das den tragenden Strukturen, wie einem Leichtbetonkern, beigemischt ist. Eine Innenschale ist zeichnerisch in der Fig. 4 gezeigt und beinhaltet vermutlich das vorgenannte Beplankungsmaterial. Der gesamte Querschnitt des Fertigdachmoduls ist überdimensioniert infolge des Einbaus dicker Thermoisolierungsschichten. Dies führt auch zur Gewichtszunahme der Dachkonstruktion. Dadurch wird der sich unterhalb der Dachkonstruktion befindende Innenraum verkleinert. Sollte der Dämmstoff dem Leichtbeton beigemischt sein, vergrößert sich der Querschnitt des Fertigdachmoduls erheblich in Hinblick auf statische Anforderungen. Die Flächenproduktivität sinkt. Nachteilig ist die Vielzahl von Rohren, Registern u.a., die zusätzlich zum Tragwerk als Wärmetauscher dienen. Diese Zusatzinstallationen sind materialaufwendig, leckageanfällig und kostenintensiv. Ein weiterer Nachteil ist die Gefahr einer Überhitzung bei dachintegrierten Energieelementen, wie bei gemischten Anordnungen von photovoltaischen und thermischen Kollektoren. Dies ist unerwünscht und führt zu einer deutlich verminderten Leistung.

Aufgabe der Erfindung ist, ein modulares Dachsystem für belüftete Dächer zu entwickeln, das material- und energieeffizienter und kostengünstiger ist und dessen bauphysikalische Eigenschaften einen verbesserten Wärmeschutz bieten, wobei die Dachhaut eine erheblich verkleinerte Gesamtdicke gegenüber der der bekannten Konstruktion aufweisen soll. Die neue, aus den Fertigdachmodulen erstellte Dachkonstruktion soll für die Montage von Kollektoren zur thermischen und elektrischen Solarnutzung und für die Montage von allen üblichen Dacheindeckungselementen, wie Platten oder Dachpfannen mit oder ohne photovoltaischen Zellen, geeignet sowie technologisch und geographisch einfach ausbaubar sein.

Diese Aufgabe wird gelöst durch ein ein Fertigdachmodul aufweisendes Dachsystem der eingangs genannten Art, bei dem das Vakuum-Isolations-Paneel vollständig von einer zusätzlichen Schutzhülle umschlossen ist, jedes Fertigdachmodul wenigstens zwei dachsparrenartig verlaufende Hohlprofile aufweist, die die tragenden, eine Last aufnehmenden Strukturen bilden, die Hohlprofile jeweils von Wasser oder Luft durchströmbare Kanäle sind und bei dem innerhalb wenigstens eines luftdurchströmten Kanals wenigstens ein Lenkelement angeordnet ist, mit dem sich der Lüftungsquerschnitt regulieren lässt.

Das modulare Dachsystem gemäß Erfindung ist gegenüber den bekannten material- und energieeffizienter und kostengünstiger. Seine bauphysikalischen Eigenschaften bieten einen verbesserten Wärmeschutz, wobei die Dachhaut eine erheblich verkleinerte Gesamtdicke gegenüber der der bekannten Konstruktion aufweisen kann. Die neue, aus den Fertigdachmodulen erstellte Dachkonstruktion soll die Möglichkeit zur Energiegewinnung langfristig sichern und weitgehend universell sein, d. h. sie soll für die Montage von Kollektoren zur thermischen und elektrischen Solarnutzung und für die Montage von allen üblichen Dacheindeckungselementen, wie Platten oder Dachpfannen mit oder ohne photovoltaischen Zellen geeignet sein.

Das Dachsystem kann demnach aus einem flachen Hohlkörper bestehen, dessen tragende Komponenten einzelne Hohlteile darstellen, welche durch luftevakuierte Isolationen gefüllt und mit wärmetauschenden Medien durchströmt sein können. Die Hohlteile können mit nanostrukturierten Werkstoffen beschichtet sein. Der flache Hohlkörper besitzt bereits als Standardmodul eine zusätzliche Eigenschaft der thermischen Energiewandlung, da die Teile des Tragwerks als Absorber dienen. Die bei den herkömmlichen Systemen üblichen, zusätzlichen Rohre, Rohrsysteme oder Register zur Energiewandlung entfallen.

Die Innenschale kann also aus wenigstens einer vakuumgedämmten Thermoisolierungsschicht bestehen, die vorzugsweise mehrere nebeneinander angeordnete Vakuum-Isolations-Paneele umfasst.

Die an sich aus dem Kühlgerätebau bekannten Vakuum-Isolations-Paneele beinhalten zu Platten verpresstes Pulver auf der Basis von Kieselsäure. Die Platte wird mit einer dünnen, vakuumdichten Folie umhüllt und die Luft evakuiert. Die Vakuum-Isolations-Paneele, im weiteren Pulverplatten genannt, zeichnen sich durch eine sehr geringe Wärmeleitfähigkeit aus, die deutlich unter dem Wert der des üblichen Dämmstoffes liegt.

Die in die Dachkonstruktion eingesetzten Vakuum-Isolations-Paneele sollen nicht nur als Material, sondern auch als ein System von erheblicher Komplexität und Empfindlichkeit betrachtet werden.

Der Stützkern der beschriebenen Vakuum-Isolations-Paneele (VIP) kann anstelle der hochdispersen Kieselsäure auch extrudiertes Polystyrol, Polyurethan, verpresste Glasfasern, Aerogel und dgl. oder Mischung davon enthalten, soweit diese durch die Bauvorschriften zugelassen sind. Dem Dämmstoff können vor der Luftevakuierung Flammschutzmittel zugegeben werden. Der Thermoisolationsstoff der Vakuum-Isolations-Paneele kann aus Nanostrukturwerkstoff, wie Kunstschaum, bestehen, dessen Partikelgröße im Nanometerbereich liegt.

Da die folienartige Umhüllung der Pulverplatte zum Befestigen nicht durchstoßen werden darf, ist eine zusätzliche, in situ hergestellte Schutzhülle zu verwenden, die zugleich beim Erstarren am Profil klebend hält. Eine solche Schutzhülle kann durch das Umschäumen der Pulverplatte im Spritzverfahren, z. B. mit PUR-Schaum und mit anderen, thixotropisch wirkenden Substanzen hergestellt werden.

Daraus resultiert, dass die mit den tragenden Strukturen verbundene Innenschale aus den luftevakuierten Pulverplatten und der zusätzlichen, geschäumten Schutzhülle bestehen kann.

Vorteilhaft ist, die Pulverplatten jeweils in einer vor Beschädigung schützenden Kassette unterzubringen. Die Pulverplatten können auch gruppenweise in der Kassette platziert werden.

Darüber hinaus kann eine Innenschale aus den luftevakuierten Pulverplatten, diese umgebenden Kassetten und Befestigungsmitteln zur Anbringung der Kassette an den tragenden Strukturen bzw. an den tragenden Profilen bestehen. Mit anderen Worten stellt die Innenschale ein Rahmen-, Dichtungs- und Montagesystem dar. Eine solche Innenschale bildet eine aussteifende und umschließende Konstruktion. Sie ist gasdicht, minimiert die wärmebrückeneffekte und dient mit einer Teilfläche der thermischen Energiewandlung.

Die umhüllte Pulverplatte kann von der Kassette teils oder vollständig umschlossen sein. Die an die Pulverplatte angepasste, ebenfalls flächige Kassette kann beispielsweise an ihrer dem Profil zugewandten Seite offen sein.

Weiterhin ist auch möglich, die Kassette mit nach oben, d. h. an die tragenden Profile zeigenden, seitlich angeordneten Laschen oder Stegen zu versehen, die die tragenden Profile einfassen.

Die Kassette selbst kann entweder fest oder abnehmbar mit den tragenden Strukturen verbunden sein. Beispielsweise kann sie in entsprechende Führungen auf Unterseite des tragenden Profils einschiebbar sein.

Die Kassette kann aus verschiedenen Materialien, beispielsweise aus dünnem Metallblech, aus Kunststoff, aus Holzwerkstoff, Glas, Verbundstoff oder aus harz- oder wachsbeschichteter, bzw. imprägnierter Pappe gefertigt sein. Die Wandung der Kassette kann aus unterschiedlichen Materialien, beispielsweise ihre der Dacheindeckung zugewandte Seite aus Metall und die gegenüberliegenden Seite aus Kunststoff bestehen. Wesentlich ist, dass die Kassette eine schützende Funktion erfüllt und die Montage von Pulverplatten erleichtert.

Die Kassette kann mit Befestigungselementen zur kraft-, form- oder stoffschlüssigen Verbindung mit den tragenden Strukturen, d. h. mit den Profilen bzw. Sparren versehen sein. Es empfiehlt sich, zur Verbindung vakuumgedämmte Stifte zu verwenden, mit denen sich die Wärmebrücken weitgehend vermeiden lassen. Ebenso ist vorteilhaft, alle übrigen Fugen und Durchdringungen dampfdicht auszuführen. Die unterschiedlichen Fugenbreiten zwischen den Kassetten können mit angepassten Dämmungsleisten ausgeglichen sein. Die Dämmungsleisten können mit Klebstoff beschichtet und mit abreißbaren Schutzfolienstreifen versehen sein. Eine Verwendung von selbstklebenden Aluminiumverbundfolienstreifen ist ebenfalls möglich.

Weiterhin können die Kassetten mit Halteclips sowie mit Abstandselementen versehen sein. Als Abstandselement wird im vorliegenden Fall ein in den Hohlraum der tragenden Strukturen hineingreifendes Abstützelement verstanden, das mit seinem Kopf bis zur Außenschale reicht und eine Auflagefläche für die kraftschlüssige Verbindung mit der Außenschale bildet.

Der thermisch und akustisch trennende Halteclip kann entweder unter den Profilen oder unter der raumseitigen Kassettenwand angeordnet sein, damit die Kassette unter die Sparren bzw. Profile in einfacher Weise geklickt werden kann.

Alternativ können durchgehend unterhalb der Profile verlaufende Clipleisten Verwendung finden, die die eventuellen Maß- und Formabweichungen wirksam ausgleichen können. Damit kann der Anschluß der Kassette.an die Profile durch eine wiederlösbare Steckverbindung gebildet sein.

Die an andere Bauteile anschließenden Kassetten, beispielsweise giebelseitige Endkassetten können durch entsprechende, offene Übergangsprofile gehaltert werden, welche an der Giebelwand angebracht sind. Die Übergangsprofile können einen komprimierbaren Dämmstoffkern enthalten, gegen den die Seitenkante der Endkassette stößt. Das offene Übergangsprofil kann mit dem anderen Bauteil verdübelt, verschraubt, verklebt oder in sonstiger Weise verbunden sein.

Die Kassettenlängs- und querstöße können durch schmale, in verbleibende Hohlräume der profilierten Seitenkanten einsetzbare Vakuumstreifen geschlossen werden.

Weiterhin kann die Kassette an ihrer dem tragenden Profil abgewandten Seite mit einer Innenverkleidung, wie Gipsplatte, versehen sein. Die Kassette kann auch profiliert sein oder eine strukturierte, raumseitige Oberfläche aufweisen.

Die Verwendung von Kassetten ermöglicht auch einen einfachen Austausch vom Dämmstoff, ohne dass die Kassette von der Dachkonstruktion abgenommen werden muss, falls die Kassette zu öffnen ist.

Nach Erfordernis können thermische Trennungen und/oder Dichtelemente, beispielsweise eine unterseitige Kontaktdichtung oder ein oberhalb aufgebrachtes, selbstklebendes Aluminium-Klebeband integriert werden. So werden die Wärmebrücken an der Innenschale komplett reduziert.

Die Innenschale mit Vakuum-Isolations-Paneelen und Kassetten erfordert in der Regel keine zusätzliche Flächenabdichtung, da sie als Dampfsperre wirkt.

Die Innenschale kann auch andere Thermoisolationssmaterialien bzw. -platten, beispielsweise Gipskarton-; Hartfaser-, Span- oder Verbundplatten beinhalten. Weiterhin ist nicht auszuschließen, als Thermoisolationssmaterialien sogenannte Nanostrukturwerkstoffe zu verwenden, beispielsweise mesoporöse oder schaumartige Materialien, deren Teilchen im Nanometermeßstab liegen.

Das neue modulare Dachsystem trägt durch ihre Kassettenkonstruktion einer längeren Lebensdauer und Kostenersparnis bei.

Ein wichtiges Merkmal der Erfindung ist, dass die Kassetten unmittelbar mit dem Medium kontaktieren können. Daher erfüllen eine wärmeübertragende Funktion.

Die die tragenden Strukturen bildenden Profile können aus Metall, beispielsweise Aluminium oder aus verzinktem Stahl, aus Kunststoff oder aus Holz bzw. Holzwerkstoff hergestellt sein.

Die tragenden Strukturen des Fertigdachmoduls bzw. des Daches können auch durch großformatige, prismatische, massive Tragkörper gebildet sein, die von der eine Thermoisolierungsschicht aufweisenden Innenschale unterlegt sind. Der Kanal bzw, die Kanäle für das zu strömende fluidische Mittel können durch die am massiven Tragkörper eingearbeiteten Aussparungen gebildet sein. Die Aussparungen können jeweils durch Auflageflächen, auf die das Dacheindeckungselement auflegbar ist, und einen gegenüber den Auflageflächen zurückversetzten Boden gebildet sein. Auf dieser Weise kann ein trogförmiger Kanal gebildet sein, der entweder während der Vorfertigung oder vor Ort bei der Montage des Fertigdachelementes am Dach durch die obere Außenschale abgedeckt ist.

Vorzugsweise ist der massive, großformatige Tragkörper aus mineralischem Material, z. B. aus Leichtbeton poriger Struktur, sogenanntem Porenbeton, hergestellt. Der Porenbeton kann armiert sein. Es ist aber auch denkbar, den massiven Tragkörper aus anderen Materialien, beispielsweise aus Verbundstoff oder porigem Leichtmetallguß herzustellen.

Der Fertigdachmodul gemäß der Erfindung hat einen etwa quaderförmigen Umriss. Es sei jedoch nicht ausgeschlossen, dass wenigstens eine seiner Flachseiten konvex oder konkav ausgebildet ist.

Die Kanäle können unterschiedliche, beispielsweise rechteckige, trapezförmige oder kreisrunde Querschnitte aufweisen. Innerhalb des Kanals kann wenigstens ein Rohr für ein im Gegenstrom fließendes, fluidisches Mittel, wie Wasser, verlaufen, wobei die Rohroberfläche durch das durch den Kanal strömende Luft umflossen werden kann. Für die wasserdurchströmten Kanäle können kunststoffbeschichtete Innenflächen vorgesehen sein. Ferner können die wasserdurchströmten Kanäle wenigstens teilweise mit einer flüssigkeitsdichten Folie verkleidet sein.

Als fluidische Mittel werden sowohl Gase, wie Luft, als auch Flüssigkeiten, wie Wasser, verstanden. Es sei darauf hingewiesen, dass mit dem Begriff "fluidische Mittel" auch alle gasförmigen oder flüssigen Wärme- oder Kälteträger bezeichnet werden können. Demnach bezieht sich die vorliegende Erfindung nicht nur auf die Belüftung des Daches, aber auch auf die Energiegewinnung.

Innerhalb des Kanals kann wenigstens ein flächiger oder rohrförmiger Perforationskörper zur Ausbalancierung des Luftvolumens verlaufen. In den Hohlräumen, bzw. den Kanälen können auch Schallschutzplatten integriert sein.

Wichtig ist, dass auf herkömmliche, überdimmensionierte Dachsparren und dazwischen platzierte, dicke Isolierungsschichten verzichtet werden kann. Dies führt zu einer niedrigen Aufbauhöhe des Fertigdachmoduls und vergrößert das gesamte Nutzvolumen des Dachaufbaus.

Von großem Vorteil ist, dass der Kanal durch ein geschlossenes Profil, wie Viereckrohr, gebildet sein kann, das anstelle des herkömmlichen Dachsparrens von vollem Querschnitt eingesetzt werden kann. Die Profile können auf Anforderung luft- oder wasserdurchströmt sein und daher als "Tragwerksabsorber" bezeichnet werden. Damit können die Tragwerksabsorber auch die herkömmlichen, verglasten Kollektor mit Gehäuse oder unverglasten Kollektoren mit Registern ersetzen. Das Tragwerk ist der Absorber und kann ohne Rohre, Verbindungen und ohne Wartungsaufwand die Überschußwärme nutzen. Lediglich einige, wenige Schnellsteckverbindungen sind zur Einbindung von Absorbern in das haustechnische System erforderlich. Diese Absorber können auch mit Regelelementes vorgerüstet sein, so dass sie lediglich aktiviert werden.

Vorteilhaft ist, dass sich die Luftströmungsbereiche, also praktisch die Kanäle innerhalb eines äußeren, insbesondere quaderförmigen Umrisses der tragenden Strukturen, d. h. der Profile bzw. des massiven Tragkörpers, erstrecken.

Zur Konstruktion des Fertigdachmoduls gehören noch Quer- und Verbindungsprofile. Ein die Profile bzw. Kanalprofile verbindendes, quer verlaufendes Element kann zur Tragwerksaussteifung, zur Luftbalancierung und als Unterkonstruktion für die großformatige Dacheindeckung dienen. So kann die übliche Holzschalung ersetzt werden.

Das Dach gemäß der vorliegenden Erfindung kann im Allgemeinen als zweischalig bezeichnet werden. Die Dacheindeckungselemente, darin auch eingeklebte Photovoltaik-Solarmodule bilden die Außenschale des Daches, die über luft- oder/und wasserdurchströmte Profile mit der Innenschale verbunden ist.

Die luft- oder/und wasserdurchströmte Profile bzw. die massiven Tragkörper bilden eine sogenannte Primärdachkonstruktion und können auch, aus geometrischem Gesichtspunkt, als mittlere Schale des Daches bezeichnet werden. Das Dacheindeckungselement kann aus Metall oder Kunststoff, aus mineralischem Material, z. B. aus Ton, aus faserigem Material, wie Holz oder Holzwerkstoff, oder aus Teerschindeln bestehen.

Die dreischalige Konfiguration bezieht sich auch auf den Fertigdachmodul, an dem bereits während der Vorfertigung eine insbesondere aus großformatigen Platten bestehende Außenschale angebracht worden ist.

Es besteht die Möglichkeit einer breiten Vorfertigung, wobei der Vorfertigungsgrad des Fertigdachmoduls variieren kann. So beispielsweise kann die Innenschale mit den tragenden Profilen, wie Viereckrohr, C-Profile oder Trapezblech, vorgefertigt und erst bei der Montage am Bauort mit der Außenschale verbunden werden. Dies ist ein niedrigster Vorfertigungsgrad des Fertigdachmoduls.

Die Innenverkleidung kann vor oder bei der Montage an den Kassetten angebracht werden. Besteht die Außenschale aus großformatigen Plattenelementen, beispielsweise aus Blechscharen, so kann diese bereits bei der Vorfertigung an den tragenden Strukturen angebracht werden. Ferner können im Rahmen der Vorfertigung photovoltaische oder gemischte Solarmodule auf die Außenschale aufgeklebt werden.

Bei der Fixierung der Solarmodulen an der plattenförmigen Außenschale sollen auch die einfache Demontage und Austauschbarkeit der Solarmodulen sowie umweltschützende Aspekte berücksichtigt werden. So wird vorgeschlagen, zur Verklebung Release-Klebestreifen oder Klettverschluß-Streifen zu verwenden. Die Release-Klebestreifen können synthetische oder natürliche Klebesubstanzen enthalten, insbesondere solche, die aufgrund der Bionik-Forschung entwickelt worden und zur flächigen, lösbaren Verbindung prädisponiert sind. Beispielsweise können sogenannte Gecko-Kleber zum Einsatz kommen, deren Anziehungskraft auf elektrostatischen Wechselwirkungen, wie bei den Van-der-Waals-Kräften, zwischen Atomen und Molekülen der beiden miteinander zu kontaktierenden Flächen beruht. Die PV-Zellen können nach Beschädigung oder Ablauf ihrer Leistungsfähigkeit wieder vom Dach gelöst werden. Dies erhöht die Qualität und Lebensdauer von Bauwerken.

Auf eine herkömmliche Zwischensparrendämmung, die einen hohen Sparrenquerschnitt bedingt, wird verzichtet. Die Aufgabe der Thermoisolierung übernimmt die durchgehende, gegenüber den üblichen dicken Platten oder Bahnen sehr schmale Hochleistungsdämmung, die unterhalb der Sparren bzw. der Profilen verläuft. Die Räume zwischen den Sparren können luftdurchströmt sein, wobei die einzelnen, als Hohlprofile ausgeführten Sparren auf Anforderung luft- oder wasserdurchströmt sein können. Dank der spürbar dünneren Dachkonstruktion können die Räumlichkeiten, wie Dachgeschoß, entsprechend vergrößert werden. Die Aufbauhöhe kann bis zu etwa 60% gegenüber der des Passivhauses reduziert werden.

Wasserdurchströmt können auch Rohre sein, die zwischen der Dacheindeckung und den tragenden Profilen verlegt sind. Diese Hohlprofile ersetzen die übliche Lattung mit Konterlattung und können ebenfalls als Tragwerksabsorber bezeichnet werden.

Das neue Dach besitzt variable, thermische Eigenschaften und kann durch Beschichtungen, Stoffe und Konstruktionselemente zur Aufnahme von Sonnenenergie und deren kombinierte Umwandlung nach Bedarf in elektrische und thermische Energie genutzt werden. Zwischen den beiden Dachschalen fungiert die Tragkonstruktion als solarthermischer Wandler. Zu den Vorteilen zählt damit ein effizienteres Energiemanagement, da der Gesamtwirkungsgrad der Strom- und Wärmeenergie auf bis zu 75% steigen kann.

Bei einer thermischen Energiegewinnung werden die segmentierten Hohlräume luft- oder/und wasserdurchströmt. Im ersten Fall absorbieren sie die Sonneneinstrahlung, wandeln diese in Wärme und geben sie an die durchströmende Frischluft ab. Durch die integrierten, luftlenkenden Elemente und den angeschlossenen Sammelkanal wird die Warmluft strömungseffizient und mit nur kleinen Energieverlusten abgekoppelt, durch die bauseitige Wärmerückgewinnung nacherwärmt und über die bauseitig vorhandenen Lüftungskanäle zur Raumheizung verwendet.

Die Hohlräume können durch einen porösen, aussteifenden Absorber, der im Gegensatz zu herkömmlichen Systemen durchströmt wird, untersegmentiert werden. Dadurch erhöht sich der Wärmekoeffizient und damit der Wirkungsgrad.

Im zweiten Fall (mit Wasser) wird die anfallende Wärme in einem geschlossenen Kreislauf abgeführt und ebenfalls haustechnisch nutzbar gemacht.

Der Fertigdachmodul besitzt also variable thermische Eigenschaften. Die luftgeführte PV-Kühlung erfolgt durch den thermischen Auftrieb ohne Energieeinsatz. Die alternative, wassergeführte PV-Kühlung erfolgt durch die Tragwerkabsorber, d. h. durch die sparrenartig verlaufenden Hohlprofile. Diese Kühlung ist in den südlichen Ländern effektiver, da im Sommer die umgebende Lufttemperatur (30 °C bis 40 °C) nicht ausreicht, um die PV-Zellen zu kühlen. Eine gemischte, luft- und wassergeführte PV-Kühlung stellt ein sich nach Lastfällen anpassender, dynamischer Betrieb dar. Für die energieeffizienteste Schaltung sorgen neue NT-Systeme. Durch die Vorrüstung wird das Dach zu einem universellen Bauteil für alle Klimazonen.

Weiterhin können in das Dachsystem thermische Sensoren (Thermorezeptoren) integriert sein. So werden die Thermorezeptoren in die Außenschale eingebaut, damit die Witterungseinflüsse und deren Veränderungen kontinuierlich bemessen und die Meßdaten über Leitungen oder mit Hilfe der Datenfernübertragung an eine Wartungsstation oder an ein gebäudeseitiges EIB-Bus-Netz weitergeleitet werden können. Die Meß- und Regelungstechnik ermöglicht es, die Solarenergie über wechselnde Wärmeträger entsprechend der jeweiligen Verbräuchen und den wechselnden Wetterbedingungen dort einzuspeisen, wo die größten Einsparungen erzielt werden können.

Weitere Vorteile der Erfindung sind:
- geringere Energierücklaufzeiten;
- Überhitzungschutz, d.h. geringere Temperaturbelastung der Dachhaut; Abschirmung gegen unerwünschte Wärmeeinstrahlung mit guter Wärmeabführ durch die Ventilation;
- keine nennenswerte Wärmebrücken;
- keine Feuchtebildung; die Hohlraumkonstruktion verhindert verengte Lüftungsquerschnitte und ermöglicht ein schnelles Austrocknen; Die Wärmedämmung wird nicht durchnäßt, sie quillt nicht auf und die Dachbauteile werden nicht durch Fäulnis angegriffen;
- Möglichkeit einer breiten Anwendung als integrierter Systemsatz zum Heizen, Lüften, Kühlen und zur Wär-Warmwasserbereitung in Gebäuden in allen Klimazonen und für alle Gebäudestandards;
- geringere Materialkosten und Materialeinsatz im Dachaufbau;
- geringere Installationskosten der Solartechnik;
- gesengte Lohnkosten durch den hohen Vorfertigungsgrad;
- Erhöhung der Terminsicherheit im Bauablauf, vergrößerte Unabhängigkeit von den Witterungseinflüssen;
- Verbesserte Vorwärmung der Außenluft selbst in der Nacht, indem die Transmissionswärmeverluste des verkleideten Daches genutzt und dem Gebäude wieder zugeführt werden können;
- reduzierte Haustechnik, da sich die Vorlauftemperaturen durch die im Dach gewonnene Niedertemperaturwärme verringern; damit steigt die Leistungzahl der Wärmepumpensysteme und erhöht sich der Jahresnutzungsgrad der Brennwertsysteme;
- die begrenzt verfügbare Dachfläche kann optimal für die Platzierung von PV-Modulen genutzt werden, weil keine Flächenkonkurrenz zwischen PV-Modulen und thermischen Modulen, wie unterhalb des Dacheindekkungselementes liegenden Kapillar-Rohrmatten, entsteht.

Die Fertigdachmodule gemäß der Erfindung eignen sich für alle Dachformen: für Zelt-, Sattel-, Walm-, Mansard-, Flach-, Shed- und Pultdächer, für gebogene Dächer und für alle Dachneigungen ab 1,5°.

Das Konstruktionsprinzip gemäß der Erfindung lässt trotz weniger Funktionsschichten (Außen- und Innenschale plus die aus Profilen bestehende mittlere Schale) vielfältige Ausführungsformen zu. Das Heiz-, Lüftungs- und Kühlsystem eines Gebäudes fordert aus der inneren Dachstruktur die Energie an, die haustechnisch erforderlich ist. Ferner ist anzudeuten, dass sich das erfindungsgemäße Konstruktionsprinzip auch für Fassaden von Bauwerken bezieht.

Die Erfindung ist in mehreren Ausführungsbeispielen anhand der Zeichnung näher erläutert. Die Figuren zeigen:
- Fig.1a: einen Fertigdachmodul zur Erstellung eines be- lüfteten Daches, mit mehreren tragenden Profi- len, in einer schematischen, perspektivischen Ansicht;
- Fig.1b: einen Fertigdachmodul gemäß der Fig. 1a, jedoch mit einer anderen Anordnung der Kanäle, ebenso in einer schematischen, perspektivischen An- sicht;
- Fig. 2: ein vergrößertes Detail des Fertigdachmoduls gemäß der Fig. 1 in einer Stirnansicht, mit ei- ner Folienbahn;

- Fig. 3: ein Schrägdach aus Fertigdachmoduls gemäß der Fig.1 in einem Längsschnitt A-A gemäß der Fig. 2;
- Fig. 4: ein Detail eines Fertigdachmoduls mit einem oberhalb der tragenden Strukturen liegenden wasserdurchströmten Hohlprofilsystem, in einer Stirnansicht;
- Fig. 5: ein Schrägdach aus Fertigdachmodulen gemäß der Fig.4, in einem Längsschnitt B-B gemäß der Fig. 4;
- Fig. 6: ein Detail eines Fertigdachmoduls mit einem un- terteilten Hohlprofil, in einer Stirnansicht;
- Fig. 7: ein Detail eines Fertigdachmoduls mit einer aus Ton-Dachpfannen bestehenden Außenschale, in ei- nem Längsschnitt;
- Fig. 8: einen Fertigdachmodul mit Trapezprofilen und einem oberhalb des Flachhohlkörpers verlaufen- den Rohrsystem, in einer Stirnansicht;
- Fig. 9: einen Fertigdachmodul mit massivem Tragkörper, in einer schematischen perspektivischen An- sicht;
- Fig. 10: den massiven Tragkörper in Draufsicht;
- Fig. 11: eine andere Ausführungsform des Fertigdachmo- duls mit massivem Tragkörper und PV-Element, in einer schematischen Stirnansicht;
- Fig. 12: den Fertigdachmodul mit dem Tragkörper gemäß der Fig. 11, mit einem die Lattung ersetzenden
- Fig. 13: wasserdurchströmten Hohlprofilsystem, in einer schematischen Stirnansicht; einen Schnitt B- B gemäß der Fig. 12 in einer vereinfachten Darstellung;
- Fig. 14: einen Fertigdachmodul in einem einfachsten Vor- fertigungsgrad, mit Trapezblech, in einer sche- matischen Darstellung;
- Fig. 15: ein Fertigdachmodul in einem einfachsten Vor- fertigungsgrad, mit Wellblech;
- Fig. 16: eine andere Ausführungsform des Fertigdachmo- duls, mit Führungen für die Kassetten, in einem schematischen Querschnitt;
- Fig. 17: einen Fertigdachmodul gemäß der Fig. 4, jedoch mit einem direkt mit der Dacheindeckungsplatten kontaktierenden Rohrregister;
- Fig. 18: Teil eines Daches mit einem Fertigdachmodul aus massiven Tragkörpern, in einem Längsschnitt senkrecht zur Traufe;
- Fig. 19: einen an profilierten Seitenkanten von Kasset- ten eingesetzten Vakuumstreifen, in einem sche- matischen Querschnitt;
- Fig. 20: ein Halteelement in Form eines Vakuumstiftes, ebenso in einem schematischen Querschnitt durch die Kassetten und das Profil;
- Fig. 21: einen Anschluß einer Endkassette an eine Gie- belwand, in zwei Ausführungen;

- Fig. 22: eine Verbindung der Kassetten mit den Dachspar- ren mittels Clippleisten, in einer schemati- schen Darstellung;
- Fig. 23: Draufsicht auf ein Satteldach, mit Schieferdek- kung;
- Fig. 24: Schema eines Niedrigenergiehauses.

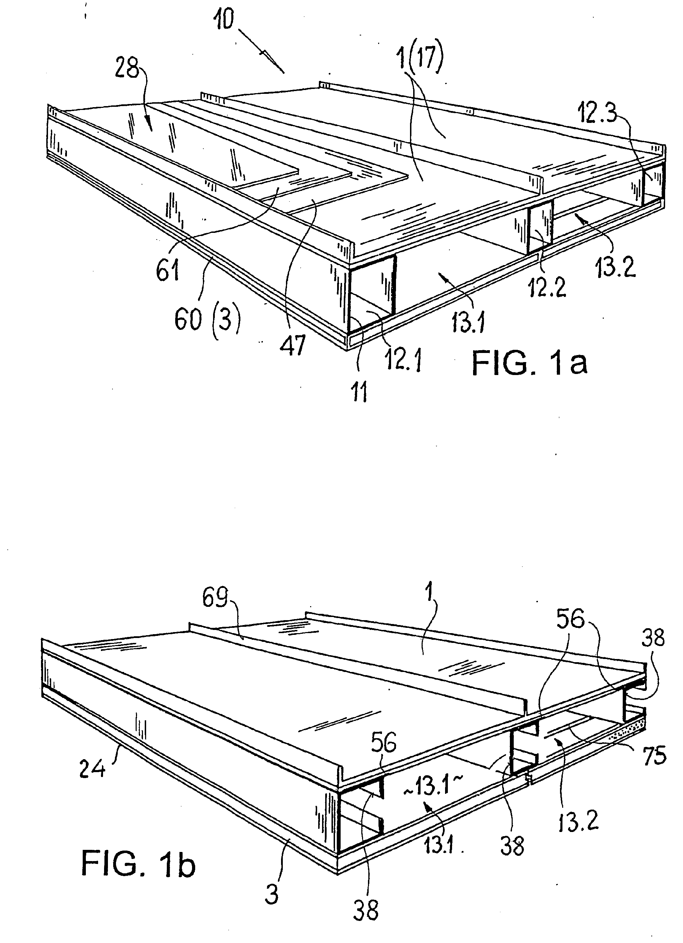

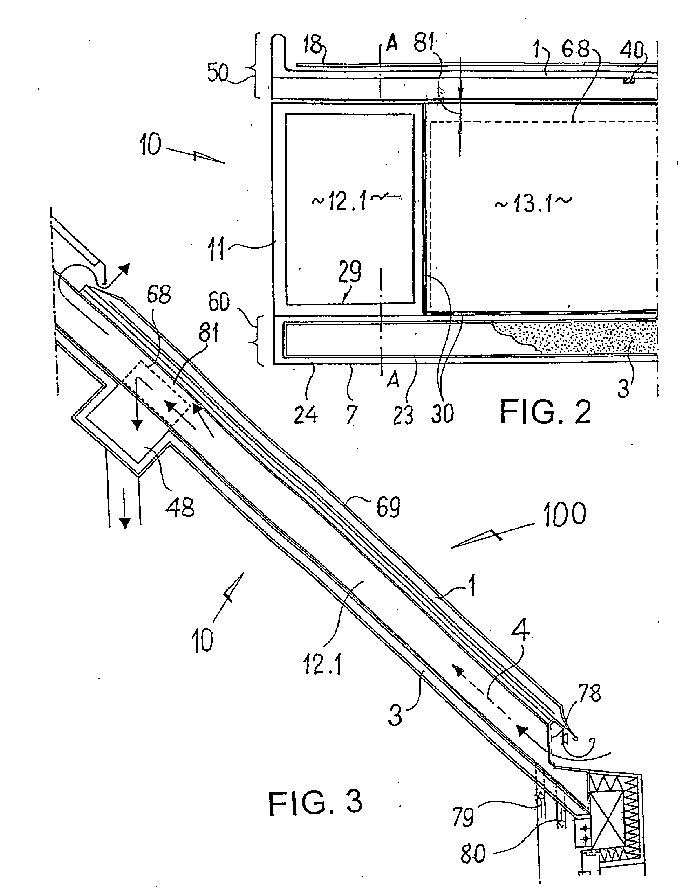

In den Figuren 1a und 2 ist ein Fertigdachmodul 10 von einem hohen Vorfertigungsgrad dargestellt, das sich aus mehreren tragenden Profilen 11, einer unterhalb der Profilen angeordneten Thermoisolierungsschicht 3 und aus einer Außenschale 50 zusammensetzt. Die Außenschale 50 setzt sich wenigstens aus einer Dacheindeckung 1, einer folienartigen Unterspannbahn 66, einem PV-Solarmodul 28 und einer Unterkonstruktion 32 zusammen. Die Dacheindekkung 1 besteht aus in Falztechnik miteinander verbundenen, großformatigen Dacheindeckungsplatten 17 aus Zinkblech. Der mit der Dacheindeckung verklebte PV-Solarmodul 28 besteht im wesentlichen aus einer Substratschicht 47, Photovoltaik-Solarzellen 61 und einer Glasabdeckung 74.

Wie das vergrößerte Detail (Fig. 2) zeigt, ist das Profil 11 als Viereckrohr ausgeführt, dessen Innere einen Kanal 12.1 für das fluidische Mittel bildet, im vorliegenden Fall für Wasser. Das Viereckrohr hat eine kunststoffbeschichtete Innenfläche 29, die das Anhaften von Belagpartikeln verhindert. Insgesamt weist der in den Figuren 1a und 2 dargestellte Fertigdachmodul 10 fünf Kanäle auf, von denen die breiteren Kanäle 13.1, 13.2 luft- und die übrigen drei Kanäle 12.1, 12,2, 12.3 von kleinerem Querschnitt wasserdurchströmt sind. Die die engeren Kanäle 12.1, 12,2, 12.3 bildenden Metallhohlprofile (Viereckrohre) entsprechen etwa dem Verlauf von herkömmlichen Dachsparren und bilden damit Konstruktionselemente zur Aufnahme der Last und deren Einleitung in die Fundamente.

Der luftdurchströmte Kanal 13.1 bzw. 13.2 ist mit einer wasserdichten, wannenförmig eingebauten Folienbahn 30 verkleidet. Als Material für die Folienbahn 30 eignen sich handelsübliche, insbesondere selbstklebende Unterspannbahnen, beispielweise sogenannte Kunststoff-Gitterfolien. Bei dieser Ausführung (Fig. 2) kann auf die normalerweise erforderliche Konterlattung verzichtet werden.

Innerhalb des luftdurchströmten Kanals befindet sich noch ein plattenförmiges Lenkelement 68, mit dem sich der Lüftungsquerschnitt regulieren lässt. Das Lenkelement 68 ist mittels nicht dargestellter Scharniere verschwenkbar oder mittels ebenfalls nicht dargestellter Führungen höhenverstellbar im Bereich eines im Firstbereich horizontal verlaufenden Luftsammelkanals 48 (vgl. Fig. 3) angeordnet. Ferner ist der Fig. 2 ein schematisch gezeigter Thermorezeptor 40 zu entnehmen, der in die Innenschale 50 eingebaut ist und mit einem nicht dargestellten, gebäudeseitigen Meß- und Regelungssystem verbunden.

Die Fig. 3 zeigt einen Längsschnitt des wasserdurchströmmten Kanals 12.1 mit einem Wassereinlauf 79 und einem Wasserablauf 80. Die Wasseranschlüsse können alternativ im Firstbereich als Anschluß an die Haustechnik installiert sein. In der Fig. 3 ist auch mit Strichlinien (da außerhalb des wasserdurchströmten Kanals 12.1 liegt) das vorgenannte Lenkelement 68 angedeutet. Die von außen her durch ein Gitterelement 78 in den Kanal 13.1 einfließende Luft (vgl. Fig. 3; Pfeile 4) gelangt in den quer verlaufenden Luftsammelkanal 48. Mit dem einstellbaren Lenkelement 68 lässt sich die Größe einer Überströmungsöffnung 81 regulieren.

Die Fig. 1b zeigt einen ähnlichen Fertigdachmodul, jedoch nicht mit geschlossenen tragenden Profilen. Die tragenden Strukturen sind durch drei parallel zueinander verlaufende C-Profile 38 gebildet, zwischen denen sich zwei luftdurströmte Kanäle 13.2, 13.2 erstrecken. Mit der Bezugszahl 75 ist eine innerhalb des Hohlraumes untergebrachte Schallschutzplatte bezeichnet. Die Außenschale ist über eine Release-Klebstoffschicht 56, hier: drei parallel zueinander verlaufende Klebstoffstreifen, mit der mittleren Schale, d. h. mit den tragenden Strukturen lösbar verbunden. Als Klebstoff ist sogenannter Gecco-Kleber vorgesehen. Ein weiterer Klebestreifen 32, bei dem sich ebenfalls um einen Gecco-Kleber handelt, ist der Fig. 2 zu entnehmen. Die Klebestreifen 32 verbinden die Solarzellen 18 mit der Dacheindeckung.

Die unterhalb der Profilen 11 liegende Thermoisolierungsschicht 3 umfasst zwei gleichformatige Vakuum-Isolations-Paneele 23 (vgl. Figuren 1a und 1b) mit hochdispersem, pulverigem Dämmstoff auf Kieselsäurebasis. Der Dämmstoff ist mit einer dünnen Aluminiumfolie umhüllt, wobei die Luft aus der umhüllten Platte evakuiert ist. Derartige auf dem Markt erhältlichen Vakuum-Isolations-Paneele (Pulverplatten) werden beispielsweise durch die Firma va-Q-tec AG, Würzburg, hergestellt.

Die Befestigung von Vakuum-Isolations-Paneelen 23 am tragenden Profil 11 stellt ein technisches Problem dar, da die folienartige Umhüllung nicht durchstoßen oder zugeschnitten werden darf. Daher sind die Pulverplatten jeweils von einer zusätzlichen, äußeren Schutzhülle 24 umgeben. Im vorliegenden Fall stellt die äußere Schutzhülle eine Kassette 7 dar, in die die Pulverplatte platziert ist, so dass diese sowohl bei der Montage als auch während der Standzeit vor mechanischen Beschädigungen geschützt ist.

Die luftevakuierten Pulverplatten 23 bilden mit den Kässetten 7 eine Innenschale 60 (vgl. insbesondere Fig. 2) des Fertigdachmoduls 10 bzw. deren Teil.

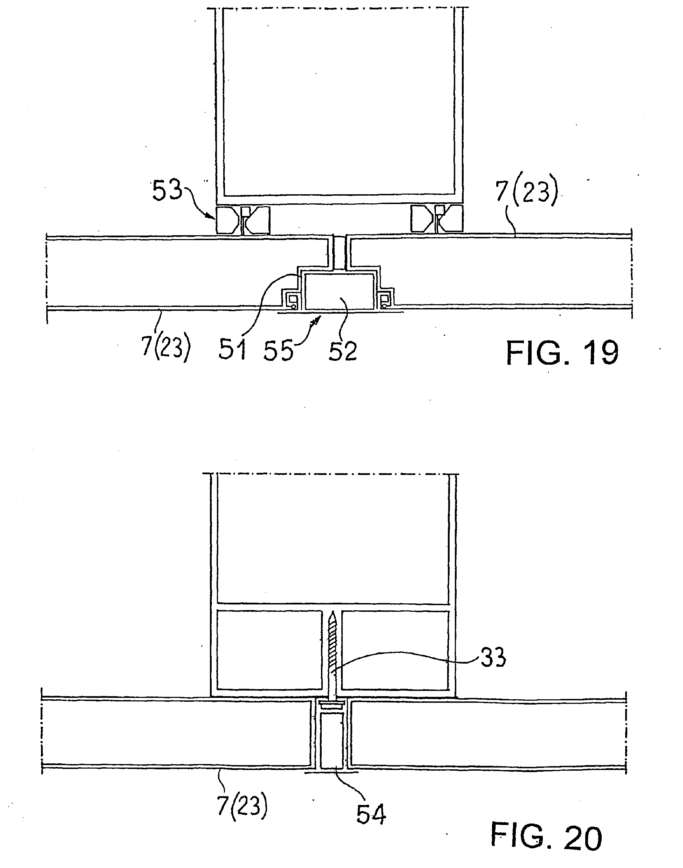

In der Fig. 19 ist ein schmaler Vakuumstreifen 52 dargestellt, welcher in einen Hohlraum 55 zwischen den Kassetten 7 eingerastet ist. Der Vakuumstreifen 52 ist ebenfalls mit einem pulverigen Dämmstoff gefüllt, der Bestandteil der Pulverplatten ist. Der Hohlraum 55 ist durch zwei aneinander gerichtete, profilierte Seitenkanten 51 der Kassetten 7 gebildet. Vorteilhaft ist, dass der die Wärmebrücke reduzierende Vakuumstreifen 52 jederzeit nach Bedarf abgenommen und wieder eingesetzt werden kann. Die Fig. 19 zeigt auch Halteclips 53, mit denen die Kassetten 7 am Profil ebenso abnehmbar angebracht werden können.

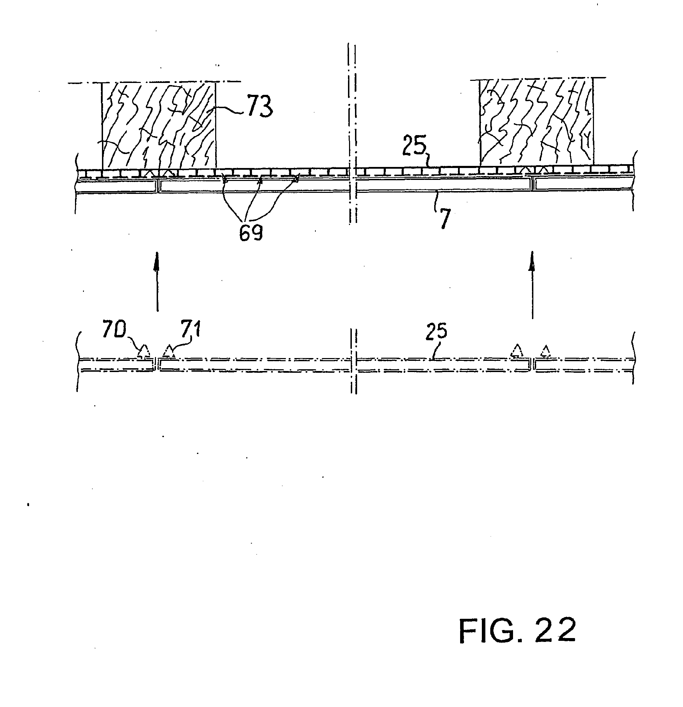

Die Fig. 22 zeigt eine wiederlösbare Steckverbindung der Kassetten 7 mit den tragenden Strukturen, im vorliegenden Fall an den Dachsparren 73. Eine quer zu den Dachsparren verlaufende Clipleiste 25 aus Hartkunststoff ist an die Unterseite der Dachsparren angeschraubt. Die Clipleiste 25 verfügt über eine Vielzahl von in mm-Abstand voneinander liegenden Öffnungen 69, in die Rastknöpfe 70, 71, die mit der Kassette 7 verbunden sind, federnd eingreifen. Die Rastknöpfe 70, 71, können über entsprechende, sparrenparallel verlaufende Leisten (nicht dargestellt) mit der Kassette verbunden sein. Auf dieser Weise können die Kassetten präzise an gewünschten Stellen angebracht werden, auch dann, wenn erhebliche Rohbauungenauigkeiten der Fertigdachmodule vorliegen.

Bei der Fig. 20 handelt sich um einen sogenannten Vakuumstift 33, mit dem die Kassetten 7 am Profil angebracht sind. Der Stift 33 kann eine gewöhnliche Schraube sein, die mit einem z.B. zylindrischen oder prismatischen Vakuumelement 54 verdeckt ist. Der Stift kann auch Teil einer Einheit sein, die einen Vakuumkopf aufweist, wobei der Stift selbst dübelartig einrastbar ist.

In den Figuren 4 und 5 ist ein Teil des Fertigdachmoduls dargestellt, bei dem oberhalb des tragenden Profils 73, jedoch unterhalb der Dacheindeckung ein Wasserrohrsystem 77 untergebracht ist. Die parallel zur Traufe verlaufenden Rohrabschnitte 76 sind innerhalb Dachlatten 65 angeordnet. Dementsprechend sind an den Dachlatten 65 längliche, U-förmige Mulden (nicht dargestellt) eingearbeitet. Hierbei handelt sich um Dachbauteile aus Holz, ausgenommen Inneschale 60 und Dacheindeckung. Demnach stellen die tragenden Profile 73 hölzerne, volle Dachsparren dar (Fig. 4), zwischen denen luftdurchströmte Kanäle 13.1, 13.2 angeordnet sind. Innerhalb des Luftkanals ist ein für die Klimatisierung vorgesehenes Rohrelement 82 angeordnet. Der Überschuß an Luft wird über eine Verengung 83 im Firstbereich nach außen abgeführt. Die für eine Holzkonstruktion vorgesehene Konterlattung ist hier weggelassen. Mit dem Längsschnitt gemäß der Fig. 5 kann auch ein Metalldachsystem beschrieben werden, bei dem nur metallene, luftdurchströmte Hohlprofile und -räume auftreten. Die hölzernen Dachlatten können durch metallene U-Profile ersetzt werden.

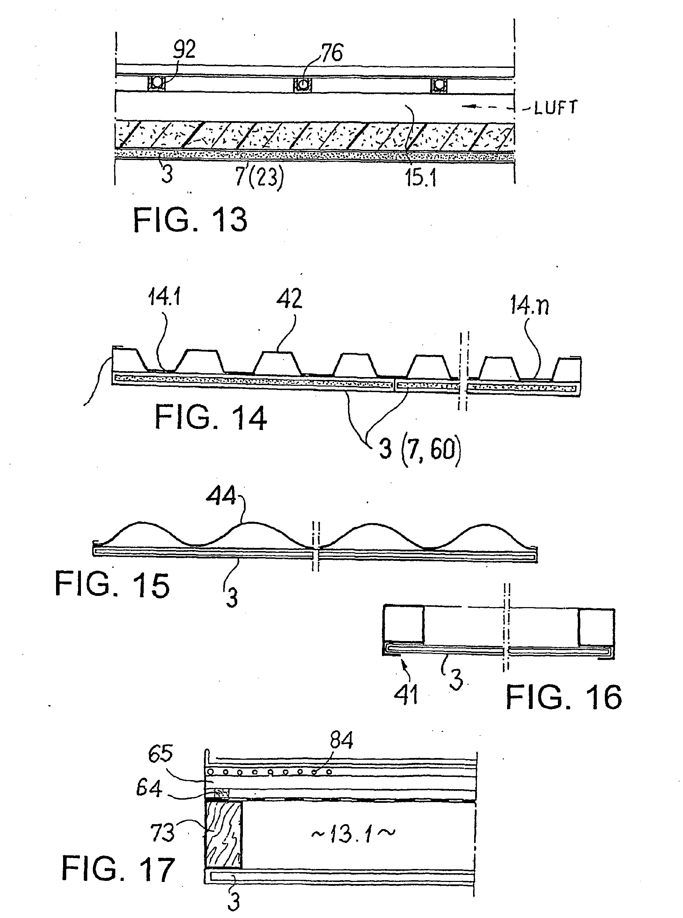

In Anlehnung an die Fig. 4 ist in der Fig. 17 eine weitere Konstruktionsmodifikation mit den massiven, sparrenartigen Tragprofilen 73 dargestellt.

So zeigt die Fig. 17 eine der Fig. 4 ähnliche Konfiguration mit dem Unterschied, dass das Wassersystem, hier: Rohrregister 84 zwischen den Dachlatten 65 und der Dacheindeckung 1 verläuft. Unterhalb der Dachlattung befinden sich noch eine Konterlattung 64 und eine zwischen der Konterlattung und dem Holzsparren angeordnete Unterspannbahn 66.

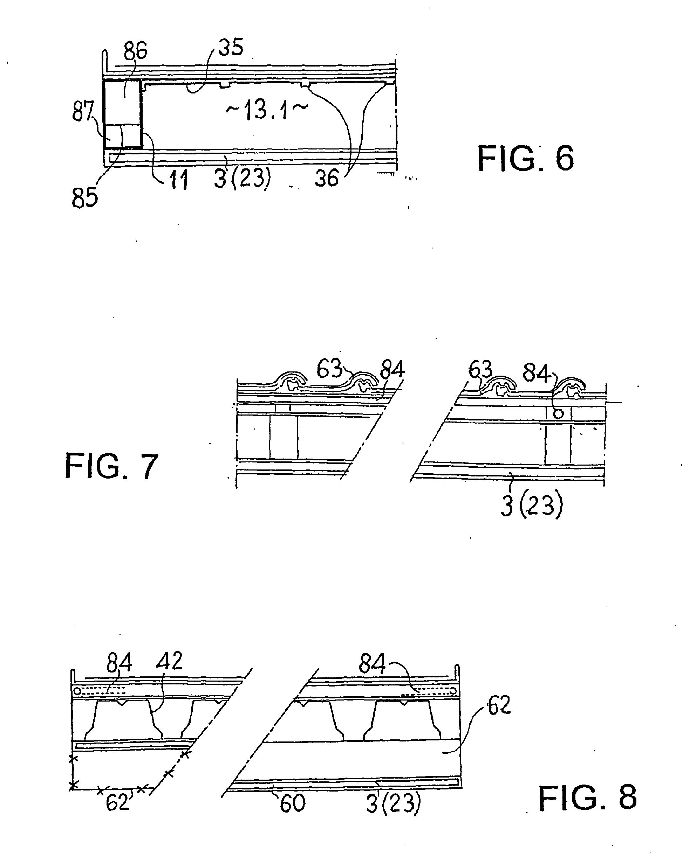

Bei der Ausführungsform gemäß der Fig. 7 handelt sich um kleinformatige Dachendeckungselemente, nämlich um profilierte Dachpfannen 63, die auf die Dachlattung verlegt sind. Die linke Seite der Figur zeigt einen innerhalb der Lattung und die rechte Seite innerhalb der Konterlattung verlaufenden Abschnitt des Rohrregisters 84. Hierbei wird darauf hingewiesen, dass der Begriff "Lattung" auch die Ausführung als Hohlprofile umfaßt. Auf die Dachpfannen 63 sind folienartige PV-Module 28, 60, 47 angeklebt.

Das in der Fig. 6 gezeigte tragende Profil 11 ist durch eine innere Zwischenwand 85 in zwei Kammern 86, 87 unterteilt, in denen gleiche oder unterschiedliche fluidisches Medien fließen können, beispielsweise in Gegenstrom Wasser und Luft. An einer Decke 35 des luftdurchströmten Kanals 13.1 sind Rippen 36 angeordnet, die die Wärmeübertragungsfläche vergrößern. Die Berippung kann an Innenflächen sowohl der luft- als auch wasserdurchströmten Kanäle angeordnet sein.

Der Fig. 8 sind sich zwischen der Dacheindeckung und der Innenschale 60 befindenden, profilierten Trapezprofile 42 zu entnehmen. Die Trapezprofile 42 können perforiert sein, damit der Luftstrom besser balanciert werden kann. Mit einer unterhalb der Innenschale 60 verlaufenden Strich-Kreuz-Linie ist eine Pfette 62 bezeichnet. Gemäß der Fig.8 verläuft das Rohrregister 84 innerhalb der Dachlattung, hier: innerhalb eines metallenen U-Profils. Das Rohrregister 84 kann direkt mit der Außenschale 50 kontaktieren. Auf der rechten Seite der Figur ist die Pfette 62 gezeigt, die zwischen der Innenschale 60 und den Trapezprofilen 42 liegt.

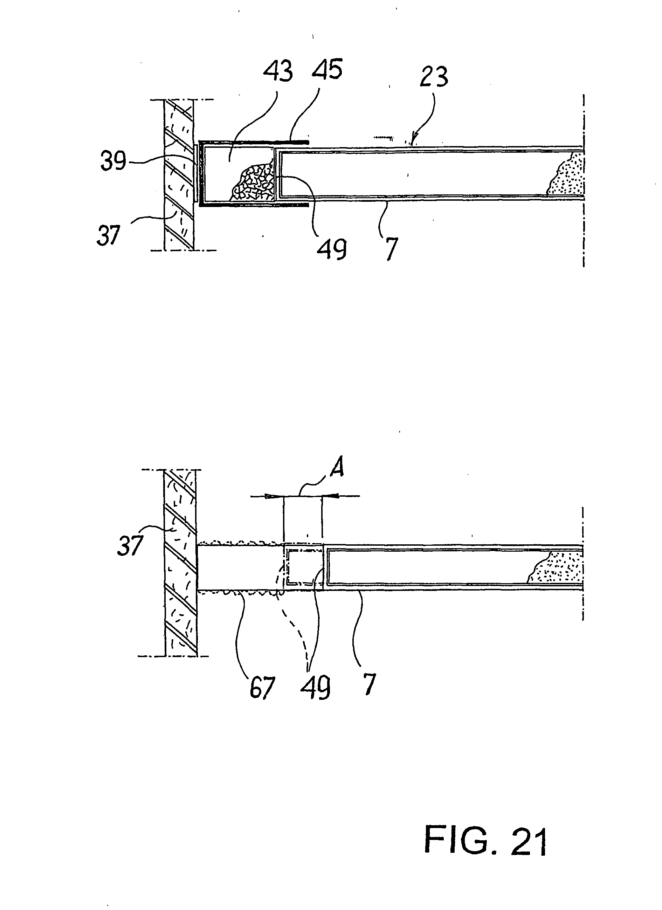

In der Fig. 21 ist die Anbringung eines mit der Kassette 7 zusätzlich umhüllten Vakuum-Isolations-Paneels 23 an einer Giebelwand 37 schematisch gezeigt. Eine giebelseitige Seitenkante 49 der Kassette 7 stößt gegen einen Dämmstoffkern 43 aus PUR-Weichschaum, der wiederum innerhalb eines U-förmigen Übergangsprofils 45 untergebracht ist. Den PUR-Weichschaums kann durch eine komprimierbare Mineralwolle, ein thermoisolierende Eigenschaften aufweisender Elastomer oder durch komprimierbare, nanostrukturierte Silika ("Nanostyropor") ersetzt werden. Das Übergangsprofil 45 ist über einen bleibend verformbaren, klebrigen Butylkautschuk-Streifen 39 mit der Giebelwand 37 verbunden. Die untere Abbildung der Fig. 21 zeigt ein komprimierbares, sich über die ganze Tiefe der Kassette erstreckendes Stößelement 67, welches mit der giebelseitigen Seitenkante 49 der Kassette 7 verbunden ist. Das Stößelement 67 unterliegt bei der Montage einer schematisch mit Ziehharmonika-Linie angedeuteten Deformation und verkürzt sich um einen Betrag A.

Die tragenden Strukturen sind gemäß der Fig. 14 durch ein Trapezblech 42 oder gemäß der Fig. 15 durch ein Wellblech 44 gebildet, das mit der unteren kassettenartigen Innenschalt 60 verklebt ist. Diese Ausführungsformen stellen einen einfachsten Vorfertigungsgrad des Fertigdachelementes dar.

Die schematische Fig. 16 zeigt ebenfalls einen Fertigdachmodul in einem niedrigen Vorfertigungsgrad. Eine Besonderheit der Konstruktion stellen Führungselemente 41 dar, die jeweils durch ein unterhalb der tragenden Profilen 11 angeordnetes L-Profil gebildet und in die die Kassetten 7 oder die Pulverplatten 23 hineingeschoben sind. Das L-Profil kann einstückig mit dem Profil 11 ausgeführt sein.

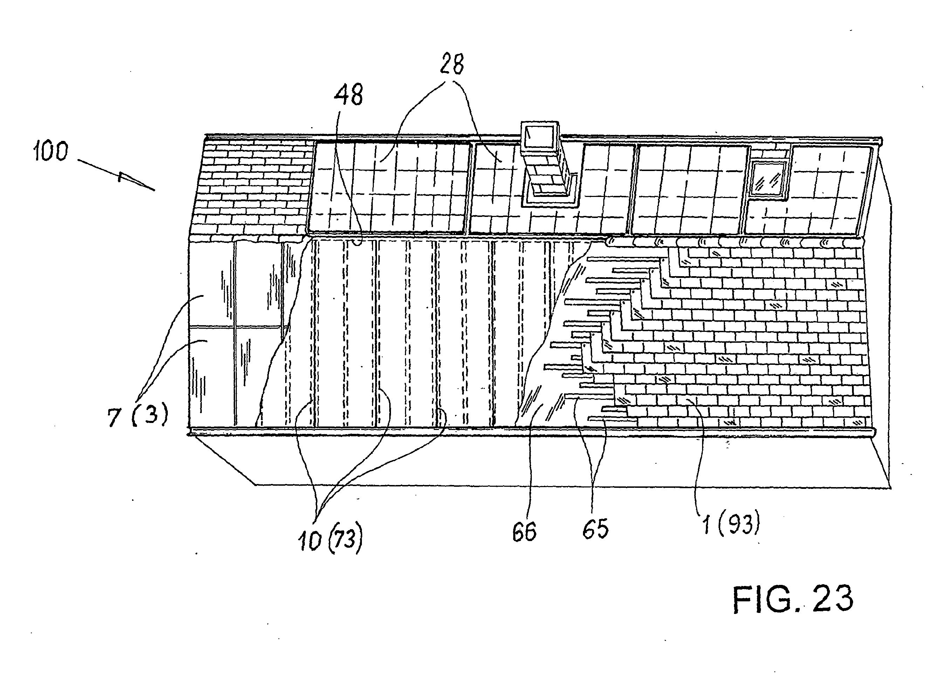

Ein komplettes, aus den Fertigdachmodulen 10 erstelltes Dach 100 ist der Fig. 23 zu entnehmen. Vorgefertigt sind die aus der Innenschale 60 und den hölzernen Dachsparren 73 bestehende Fertigdachmodule, die erst am Bauort mit einer Unterspannbahn 66, Lattung 65 und Schierferplatten 93, Teerdachschindeln, bzw. noch zusätzlich mit PV-Modulen 28, 47, 61 gedeckt sind.

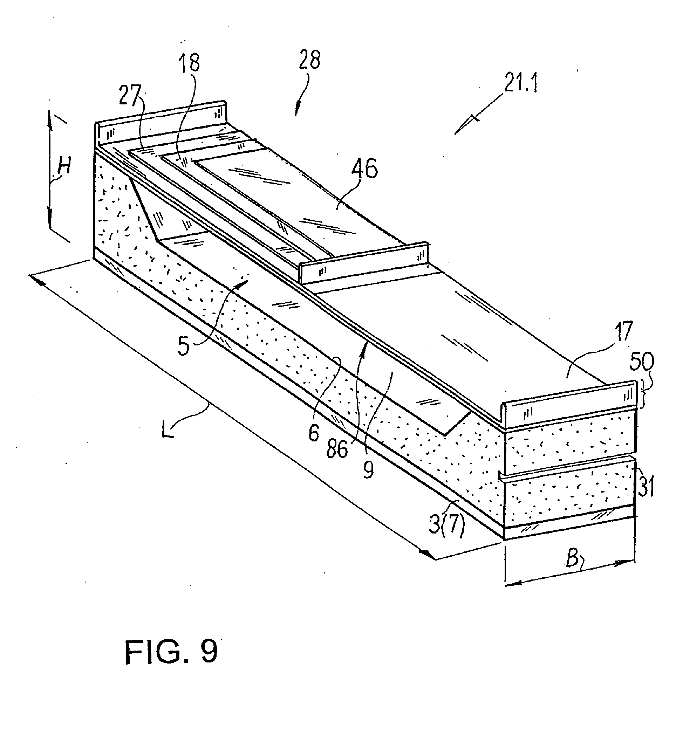

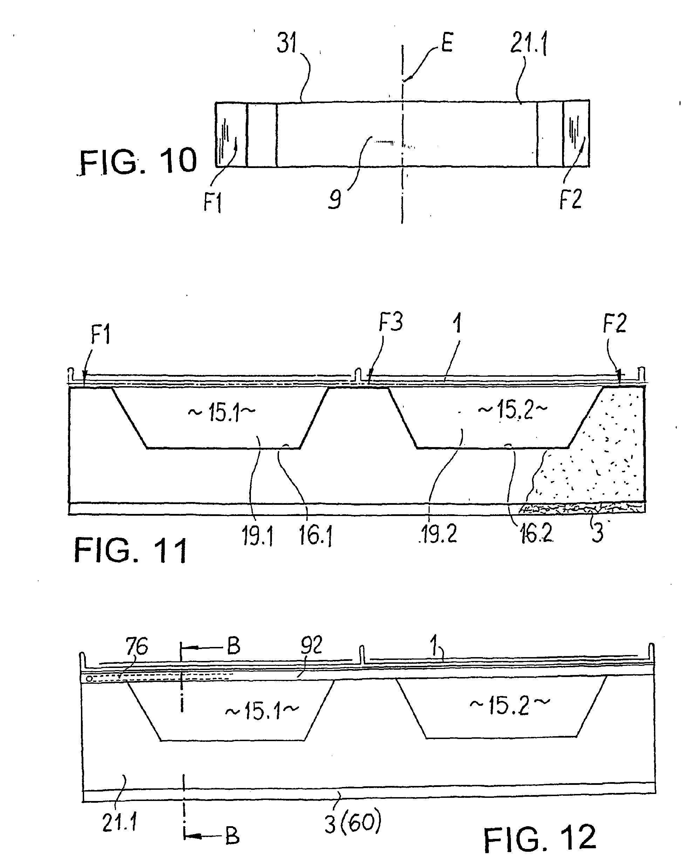

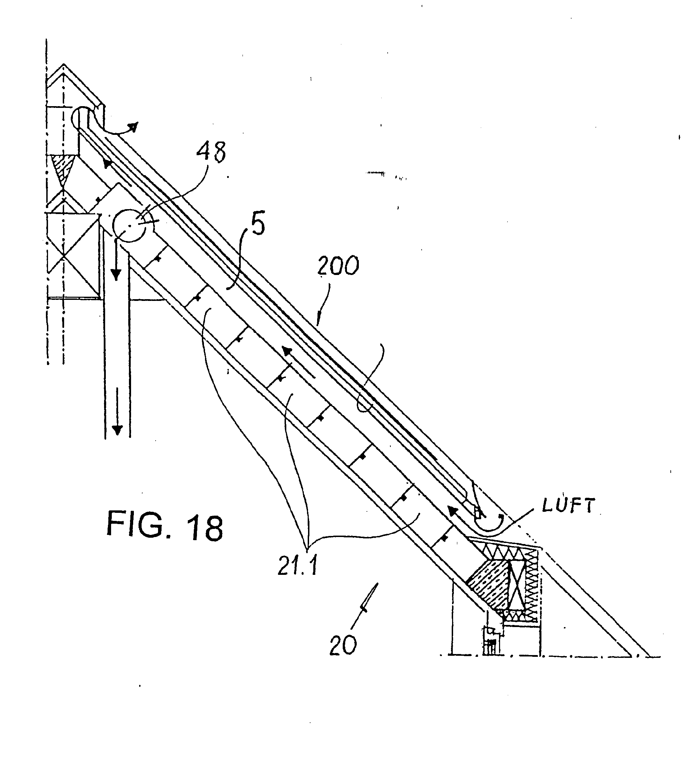

Die Fig. 18 zeigt Teil eines Massivdaches 200, das sich aus mehreren Fertigdachmodulen 20 (in der Figur ist nur ein Fertigdachmodul 20 gezeigt) zusammensetzt. Jeder einzelne Fertigdachmodul 20 besteht wiederum aus mehreren in den Figuren 9 und 10 gezeigten, massiven Tragkörper 21.1 aus Porenbeton. Der massive Tragkörper 21.1 ist ebenfalls von einer bereits beschriebenen Innenschale 60 unterlegt. Mehrere, zu einem Fertigdachmodul 20 zusammengestellte Tragkörper 21.1 sind mit den Kassetten 7 kraftschlüssig verbunden. Die massiven Tragkörper sind großformatige Vollmontagebauteile, die im Verbund das Massivdach 200 ergeben.

Jeder Tragkörper 21.1. weist zwei zueinander spiegelsymmetrisch liegende Auflageflächen F1, F2 auf, auf die erst bei der Montage am Bauort die Außenschale 50 auflegbar ist.

Am Tragkörper 21.1 ist eine durchgehende, trogförmige Aussparung 9 eingearbeitet, die einen gegenüber den Auflageflächen F1, F2 zurückversetzten Boden 6 aufweist und die einen Kanal 5 für die Luftdurchströmung bildet. Der Kanal ist über Zu- und Abluftöffnungen mit der Außenluft verbunden. Wie die Fig. 18 zeigt, gelangt der Luftstrom infolge des thermischen Auftriebs durch den Kanal 5 nach oben in den Firstbereich und weiter in den sich horizontal erstreckenden Luftsammelkanal 48. Der Luftsammelkanal ist in einer gesonderten Porenbetondiele eingelassen und verengt den Lüftungsquerschnitt auf ein strömungstechnisch günstiges Maß, so dass das Luftvolumen in vollem Umfang abgeführt werden kann. Der einzelne Tragkörper weist folgende Maße:
Länge L = 5,0 m
Höhe H = 250 mm
Breite B = 650 mm
   auf, wobei diese variieren können.

Die Außenschale 50 besteht aus metallenen Dacheindekkungselementen 17, die von einer nicht dargestellten Trennlage unterlegt sind und gegebenenfalls aus angeklebten PV-Modulen 28 (vgl. Fig. 9). Die PV-Module 28 setzen sich im vorliegenden Fall aus einer Kunststoff-Substratschicht 27, amorfen Solarzellen 18 und einer transparenten, folienartigen Abdeckung 46 zusammen. Der luftdurchströmte Hohlraum bzw. Kanal 5 ist durch die Ausparrung 9 und direkt durch eine Unterseite 86 der Dacheindeckung begrenzt, so dass ein flächenmäßig umfassender Kontakt der Lüftungsströmung mit der Dacheindekkung und ein guter Wärmeübergang gesichert ist.

Bei einer Höhe > 150 mm des Lüftungsquerschnitts empfiehlt sich, in den Kanal 5 einen luftbalancierenden, flachen Perforationskörper (nicht dargestellt) zu platzieren. Ein solcher in die schrägen Wände der Aussparung 9 eingebaute Perforationskörper kann die Konstruktion versteifen und zugleich die Zwangskonvektion fordern.

Die Figuren 11, 12 und 13 zeigen einen zweikammerigen Tragkörper 21.2. Der Tragkörper 21.2 hat drei Auflageflächen F1, F2, F3 und zwei Aussparungen 19.1, 19.2 mit den zurückversetzten Böden 16.1, 16.2, so dass zwei luftdurchströmte Kanäle 15.1, 15.2 entstanden sind.

Gemäß den Figuren 12 und 13 ist die Sekundärkonstruktion (Dachlattung) wasserdurchströmt. Die Dachlattung besteht aus metallenen U-Profilen 92, in denen die Rohrabschnitte 76 geführt sind. Bei einer nicht dargestellten, weiteren Ausführungsform sind die Dachlatten aus geschlossene Hohlprofilen gefertigt, durch die das Medium, d.h. Flüssigkeit oder Gas, wie Luft, fließen kann. Die Hohlräume der Dachlatten können mit den übrigen Hohlräumen der tragenden Strukturen in Kontakt stehen.

Demnach können die in den Figuren 11 bis 13 gezeigten Tragkörper 21.1, 21.2 und damit die aus den Tragkörper zusammengestellten Fertigdachmodule luft- und wasserduchströmt sein. Die eingebauten solarthermischen Wandler (Figuren 12 und 13) verbessern den Wirkungsgrad des Hybridsystems. Vorteilhaft ist die unkomplizierte Realisierung durch die werkseitige Vorfertigung. Die neuen Porenbetonbauteile (Tragkörper) zeichnen sich durch ein gegenüber der bekannten Porenbetonplatten erheblich reduziertes Gewicht aus. Daher müssen die Wände nicht mehr für das Mehrgewicht ausgelegt werden.

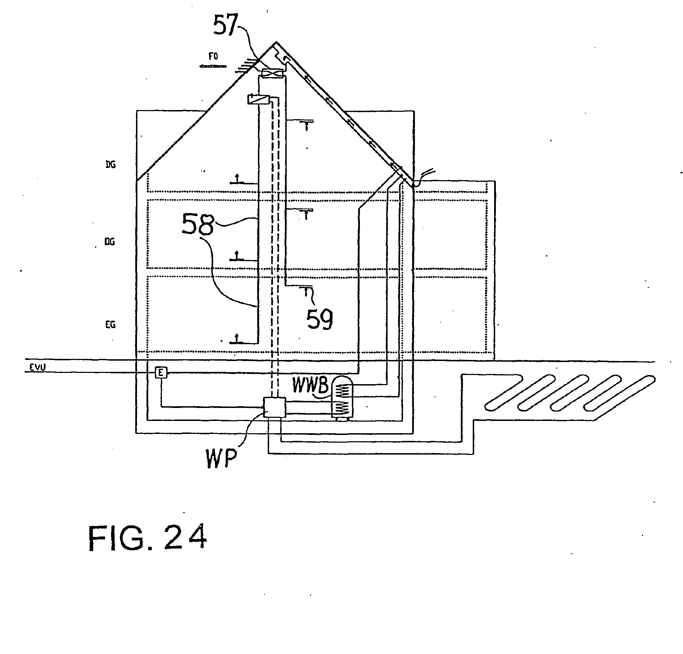

Anhand des in der Fig. 24 dargestellten Schaltschema wird die Funktion eines Energiesystems erläutert. Das beschriebene modulare Dachsystem ist in ein Gesamtsystem zur Energieversorgung eines Gebäudes eingebunden. Die frische, kühle Außenluft wird im Traufenbereich angesaugt, im Dach erwärmt und infolge der Konvektion, ohne Energieaufwand im Firstbereich entlüftet. Die Warmluft kann über einen nicht dargestellten Bypass abgekoppelt, durch den horizontal angeordneten Luftsammelkanal 48 (vgl. Fig. 3) abgeführt und nach Bedarf haustechnisch genutzt werden. Die Luft wird zu einem dachintegrierten Lüftungsgerät 57 mit Wärmerückgewinnung geführt, nacherwärmt und über Wärmeverteilleitungen 58 mit raumsparrenden Quelluftauslässen 59 in den einzelnen Räumen schnell und behaglich verteilt. Über einen Nachtheizregister der integrierten Niedertemperaturheizung, hier: eine erdgekoppelte Wärmepumpe WP wird bei relativ niedrigen Außentemperaturen die Zuluft auf das erforderliche Temperaturniveau gebracht. Zur Wärmeverteilung werden auch die ohnehin vorhandenen Lüftungskanäle genutzt. In einem Synergieeffekt wird die Abwärme der PV-Module genutzt und dadurch ihre Zelltemperatur gesenkt, wodurch sich der Wirkungsgrad des Generators erhöht. Die PV-Module greifen nahtlos in das Energiesystem ein und liefern mindestens Hilfsenergie für Ventilatoren, Pumpe etc. Bei höheren Temperaturen, wie im Sommer, kann zusätzlich die Überschußwärme, die nach Klimazone variiert, zur Brauchwasserwärmung genutzt werden. Die auf Anforderung durchströmten Hohlprofile bzw. Kanäle sind Teil eines geschlossenen Kreislaufs. Die erhitzte Wärmeträgerflüssigkeit wird in einen Solarspeicher gepumpt, heizt über den Wärmetauscher (WWB) bzw. Wärmeumpe (WP) das Brauchwasser und fließt abgekühlt in die Wandlerprofile zurück. Diese kühlen wiederum die PV-Module und die umgebende Luft. Das Komfort für den Nutzer wird deutlich erhöht- Die Emissionen sinken drastisch, da sich der Energiebedarf um mindestens 50% reduziert. Anstatt der Wärmeumpe kann zur Restwärmegewinnung auch ein Brennwertsystem im Verbindung mit einer Fußbodenheizung mit integriertem Hohlbodenlüftungssystem verwendet werden. Von Vorteil ist die Reduzierung der thermischen Träglast von Flächenheizungen und die individuellere regelung der Raumtemperatur.

Von Vorteil ist der verbesserte winterliche und sommerliche Wärmeschutz im Vergleich zur herkömmlichen Niedrigenergiebauweise. Der Regel-U-Wert_{NEH} von 0,2 W/(m²K) kann auf den U-Wert_{VIP} < 0, 1 W/(m²K) gesenkt werden. Der extrem niedrige Wärmedurchgangskoeffizient vermindert die Energieverluste deutlich.

### Bezugszeichenliste:

- 1: Dacheindeckungselement
- 2: (tragende) Struktur
- 3: Thermoisolierungsschicht
- 4: Luft
- 5: Kanal
- 6: Boden
- 7: Kassette
- 9: Aussparung (v. 21.1, 21.2)
- 10: Fertigdachmodul
- 11: Profil
- 12.1,...12.3: Kanal
- 13.1, 13.2: Kanal
- 14.1...14.n: Kanal
- 15.1, 15.2: Kanal
- 16.1, 16.2: Boden
- 17: Dacheindeckungsplatte
- 18: Solarzelle
- 19.1, 19.2: Aussparung (v. 21.1, 21.2)
- 20: Fertigdachmodul
- 21.1; 21.2: Tragkörper (massiv)
- 23: Vakuum-Isolations-Paneel
- 24: Schutzhülle
- 25: Clipleiste
- 27: Kunststoff-Substratschicht
- 28: PV-Solarmodul
- 29: Innenfläche (v. Kanal)
- 30: Folienbahn
- 31: Umriss (v. 21.1, 21.2)
- 32: Klebfolienstreifen
- 33: Stift
- 35: Decke
- 36: Rippe
- 37: Giebelwand
- 38: C-Profil
- 39: Butylstreifen
- 40: Thermorezeptor
- 41: Führungselement
- 42: Trapezprofil
- 43: Dämmstoffkern
- 44: Wellblech
- 45: Übergangsprofil
- 46: Abdeckung
- 47: Substratschicht
- 48: Sammelkanal
- 49: Seitenkante
- 50: Außenschale
- 51: Seitenkante (v. 7)
- 52: Vakuumstreifen
- 53: Halt-clip
- 54: Vakuum-Haltekopf
- 55: Hohlraum
- 56: Release-Klebstoffschicht
- 57: Lüftungsgerät
- 58: Wärmeverteilleitung
- 59: Quelluftauslaß
- 60: Innenschale
- 61: Photovoltaik-Solarzelle
- 62: Pfette
- 63: Dachpfanne (profiliert)
- 64: Konterlattung
- 65: Dachlatte (U- oder Hohlpropfil)
- 66: Unterspannbahn
- 67: Stößelement
- 68: Lenkelement
- 69: Öffnung
- 70,71: Rastknopf
- 72:
- 73: Dachsparren (Holz)
- 74: Glasabdeckung
- 75: Schallschutzplatte
- 76: Rohrabschnitt
- 77: Wasserrohrsystem
- 78: Gitterelement
- 79: Wassereinlauf
- 80: Wasserablauf
- 81: Überströmungsöffnung
- 82: Rohrelement
- 83: Verengung
- 84: Wasserrohrregister
- 85: Zwischenwand
- 86: Unterseite (Fig. 12)
- 87: Kapillar-Rohrmatte
- 88: Paneel (v. 87; Fig. 17)
- 89:
- 90:
- 91:
- 92: U-Profil
- 93: Schieferplatte (v. 1)
- 100; 200: Dachsystem
- A: Betrag
- B: Breite
- E: Symmetrieebene
- F1, F2, F3: Auflagefläche
- H: Höhe
- L: Länge
- WP: Wärmepumpe
- WWB: Wärmetauscher

## Patentansprüche

1. Gedämmtes, modulares Dachsystem (100), aufweisend wenigstens ein Fertigdachmodul (10), das wenigstens einen Strömungskanal (12.1, 12.2, 12.3; 13.1, 13.2; 5; 15.1, 15.2) für ein fluidisches Mittel und tragende Strukturen umfasst, die mit einer planen, der Sonneneinstrahlrichtung abgewandten Innenschale (60) unterlegt sind, die aus wenigstens einem umhüllten, luftevakuierten, plattenförmigen Vakuum-Isolations-Paneel (23) besteht, das eine Thermoisolierungsschicht (3) bildet, **dadurch gekennzeichnet, dass**
- das Vakuum-Isolations-Paneel (23) vollständig von einer zusätzlichen Schutzhülle (24) umschlossen ist;
- jedes Fertigdachmodul wenigstens zwei dachsparrenartig verlaufende Hohlprofile (11; 38; 42; 44) aufweist, die die tragenden, eine Last aufnehmenden Strukturen bilden;
- die Hohlprofile (11; 38; 42; 44) jeweils von Wasser oder Luft durchströmbare Kanäle sind;
- und dass innerhalb wenigstens eines luftdurchströmten Kanals wenigstens ein Lenkelement (68) angeordnet ist, mit dem sich der Lüftungsquerschnitt regulieren lässt.

2. Dachsystem nach Anspruch 1, **dadurch gekennzeichnet, dass** derselbe Kanal (12.1, 12,2, 12.3; 13.1, 13.2) auf Wasser- oder Luftströmung umschaltbar ist.

3. Dachsystem nach Anspruch 1 und 2, **dadurch gekennzeichnet, dass** die Durchströmung der Kanäle (12.1, 12,2, 12.3; 13.1, 13.2) über wechselnde Wärmeträger je nach Temperatur über in eine Außenschale (50) integrierte Thermorezeptoren (40) des Fertigdachmoduls (10) regulierbar ist.

4. Dachsystem nach Anspruch 3, **dadurch gekennzeichnet, dass** in die Außenschale (50) des Fertigdachmoduls (10) Thermorezeptoren (40) integriert sind, die wiederum in ein gebäudeseitiges Mess- und Regelungssystem über Leitungen oder kabellos eingebunden sind.

5. Dachsystem nach Anspruch 1, **dadurch gekennzeichnet, dass** die Kanäle (12.1, 12,2, 12.3; 13.1, 13.2) unterschiedlich breit sind.

6. Dachsystem nach Anspruch 1, **dadurch gekennzeichnet, dass** die Schutzhülle (24) eine Kassette (7) ist.

7. Dachsystem nach Anspruch 6, **dadurch gekennzeichnet, dass** die Kassette (7) aus Metall besteht.

8. Dachsystem nach Anspruch 7, **dadurch gekennzeichnet, dass** die Kassette (7) aus Edelstahlblech gefertigt ist.

9. Dachsystem nach Anspruch 6, **dadurch gekennzeichnet, dass** die Kassette (7) aus Kunststoff besteht.

10. Dachsystem nach Anspruch 6 **dadurch gekennzeichnet, dass** die Kassette (7) aus harz- oder wachsbeschichteter, bzw. imprägnierter Pappe besteht.

11. Dachsystem nach Anspruch 6, **dadurch gekennzeichnet, dass** die Kassette (7) aus Holzwerkstoff besteht.

12. Dachsystem nach Anspruch 6, **dadurch gekennzeichnet, dass** die Kassette (7) aus Glas besteht.

13. Dachsystem nach Anspruch 1, **dadurch gekennzeichnet, dass** die Schutzhülle (24) durch Umschäumen des Vakuum-Isolations-Paneels (23) entstanden ist.

14. Dachsystem nach einem der vorhergehenden Ansprüche, **dadurch gekennzeichnet, dass** die tragenden Hohlprofile von der Kassette (7) eingefasst sind.

15. Dachsystem nach einem der vorhergehenden Ansprüche, **dadurch gekennzeichnet, dass** die Kassette (7) mit Befestigungselementen zur kraft-, form- oder stoffschlüssigen Verbindung mit dem tragenden Hohlprofil versehen ist.

16. Dachsystem nach Anspruch 15, **dadurch gekennzeichnet, dass** die Befestigungselemente thermoisolierende Stifte (33) sind.

17. Dachsystem nach einem der vorhergehenden Ansprüche, **dadurch gekennzeichnet, dass** die Kassetten (7) über lösbare Steckverbindungen an den tragenden Strukturen befestigbar sind.

18. Dachsystem nach Anspruch 16, **dadurch gekennzeichnet, dass** die Steckverbindung eine Clipleiste (25) umfasst, die über eine Vielzahl von Öffnungen (69) verfügt, in die wiederum mit der Kassette (7) verbundene Rastknöpfe (70, 71) federnd eingreifen.

19. Dachsystem nach einem der vorhergehenden Ansprüche, **dadurch gekennzeichnet, dass** der Kanal (5; 12.1, 12.2, 12.3; 13.1, 13.2, 14.1, 14.2; 15.1, 15.2; 65; 76)) eine kunststoffbeschichtete, sauerstoffdiffusionsdichte Innenfläche (29) aufweist.

20. Dachsystem nach einem der vorhergehenden Ansprüche, **dadurch gekennzeichnet, dass** wenigstens einer der luftdurchströmten Kanäle (13.1, 13.2) wenigstens teilweise mit einer selbstklebenden, flüssigkeitsdichten Folienbahn (30) verkleidet ist.

21. Dachsystem nach einem der vorhergehenden Ansprüche, **dadurch gekennzeichnet, dass** das tragende Hohlprofil (11) durch eine innere Zwischenwand (85) in zwei Kammern (86, 87) unterteilt ist.

22. Dachsystem nach einem der vorhergehenden Ansprüche, **dadurch gekennzeichnet, dass** unterhalb des tragenden Hohlprofils Führungselemente (41) zum Einschieben von Kassetten (7) angeordnet sind.

23. Dachsystem nach Anspruch 22, **dadurch gekennzeichnet, dass** die Führungselemente (41) L-Profile sind.

24. Dachsystem nach einem der vorhergehenden Ansprüche, **dadurch gekennzeichnet, dass** zwischen dem umhüllten Vakuum-Isolationspaneel (23) und den Kanälen eine Pfette (62) angeordnet ist.

25. Dachsystem nach einem der vorhergehenden Ansprüche, **dadurch gekennzeichnet, dass** das Fertigdachmodul wenigstens einen Abschnitt (46) eines quer zu den Kanälen verlaufenden Sammelkanals (48) aufweist.

26. Dachsystem nach einem der vorhergehenden Ansprüche, **dadurch gekennzeichnet, dass** zwischen den tragenden Strukturen und einer Dacheindeckung (1, 17) der Außenschale (50) ein Wasserrohrsystem verläuft, dessen Rohre innerhalb Dachlatten (65) angeordnet sind.

27. Dachsystem nach Anspruch 26, **dadurch gekennzeichnet, dass** die Dachlatten (65) geschlossene Hohlprofile sind, deren Hohlräume mit den übrigen Hohlräumen der tragenden Strukturen in Kontakt stehen.

28. Dachsystem nach Anspruch 26, **dadurch gekennzeichnet, dass** die Rohre des Wasserrohrsystems innerhalb hölzernen Dachlatten (65) verlaufen, in denen U- oder V-förmige Mulde eingearbeitet ist.

29. Dachsystem nach Anspruch 26, **dadurch gekennzeichnet, dass** die Dachlatten (65) metallene U-Profile (92) sind, und dass innerhalb der Dachlatten parallel zur Traufe verlaufende Rohrabschnitte (76) angeordnet sind.

30. Dachsystem nach einem der vorhergehenden Ansprüche, **dadurch gekennzeichnet, dass** die Kanäle (12.1, 12,2, 12.3; 13.1, 13.2, 65, 76, 92) an wenigstens ein umlaufendes Luft- oder Wassersystem angeschlossen sind.

31. Dachsystem nach einem der vorhergehenden Ansprüche, **dadurch gekennzeichnet, dass** die luftdurchströmten Kanäle (13.1, 13.2) zwischen massiven Profilen (73) angeordnet sind.

32. Dachsystem nach Anspruch 1, **dadurch gekennzeichnet, dass** die Außenschale (50) über eine Release-Klebstoffschicht (56) mit den tragenden Strukturen lösbar verbunden ist.

33. Dachsystem nach Anspruch 1, **dadurch gekennzeichnet, dass** auf die Außenschale (50) photovoltaische Solarzellen oder -module (18; 28) über ablösbare Release-Klebestreifen (32) aufgeklebt sind.

## Claims

1. Insulated modular roof system (100) comprising at least one prefabricated roof module (10) which includes at least one flow channel (12.1, 12.2, 12.3; 13.1, 13.2; 5; 15.1, 15.2) for a fluid medium and supporting structures, under which there is laid a planar inner shell (60) facing away from the direction of solar radiation and consisting of at least one enclosed, air-evacuated, plate-like vacuum insulation panel (23) which forms a thermal insulation layer (3), **characterised in that**
- the vacuum insulation panel (23) is completely surrounded by an additional protective sleeve (24);
- each prefabricated roof module comprises at least two hollow profiles (11; 38; 42; 44) which extend in a rafter-like manner and form the supporting load-bearing structures;
- the hollow profiles (11; 38; 42; 44) are each channels through which water or air can flow;
- and **in that** within at least one channel through which air flows there is disposed at least one baffle element (68), by means of which the ventilation cross-section can be adjusted.

2. Roof system as claimed in Claim 1, **characterised in that** the same channel (12.1, 12.2, 12.3; 13.1, 13.2) can be switched between a water flow or an air flow.

3. Roof system as claimed in Claim 1 and 2, **characterised in that** the flow through the channels (12.1, 12.2, 12.3; 13.1, 13.2) by alternating heat carriers can be adjusted in dependence upon temperature via thermoreceptors (40) of the prefabricated roof module (10) which are integrated into an outer shell (50).

4. Roof system as claimed in Claim 3, **characterised in that** integrated into the outer shell (50) of the prefabricated roof module (10) are thermoreceptors (40) which in turn are incorporated into a building-side measuring and controlling system via conduits or in a cable-free manner.

5. Roof system as claimed in Claim 1, **characterised in that** the channels (12.1, 12.2, 12.3; 13.1, 13.2) have different widths.

6. Roof system as claimed in Claim 1, **characterised in that** the protective sleeve (24) is a cartridge (7).

7. Roof system as claimed in Claim 6, **characterised in that** the cartridge (7) consists of metal.

8. Roof system as claimed in Claim 7, **characterised in that** the cartridge (7) is produced from a stainless steel sheet.

9. Roof system as claimed in Claim 6, **characterised in that** the cartridge (7) consists of synthetic material.

10. Roof system as claimed in Claim 6, **characterised in that** the cartridge (7) consists of resin- or wax-coated or impregnated board.

11. Roof system as claimed in Claim 6, **characterised in that** the cartridge (7) consists of a derived timber product.

12. Roof system as claimed in Claim 6, **characterised in that** the cartridge (7) consists of glass.

13. Roof system as claimed in Claim 1, **characterised in that** the protective sleeve (24) is created by foaming the vacuum insulation panel (23).

14. Roof system as claimed in any one of the preceding Claims, **characterised in that** the supporting hollow profiles are enclosed by the cartridge (7).

15. Roof system as claimed in any one of the preceding Claims, **characterised in that** the cartridge (7) is provided with attachment elements for the purpose of connecting to the supporting hollow profile in a non-positive, positive or firmly bonded manner.

16. Roof system as claimed in Claim 15, **characterised in that** the attachment elements are heat-insulating pins (33).

17. Roof system as claimed in any one of the preceding Claims, **characterised in that** the cartridges (7) can be attached to the supporting structures via releasable plug-in connections.

18. Roof system as claimed in Claim 16, **characterised in that** the plug-in connection includes a clip strip (25) which has a plurality of openings (69) into which latching studs (70, 71), in turn connected to the cartridge (7), are resiliently engaged.

19. Roof system as claimed in any one of the preceding Claims, **characterised in that** the channel (5; 12.1, 12.2, 12.3; 13.1, 13.2, 14.1, 14.2; 15.1, 15.2; 65; 76) has an inner surface (29) which is coated with synthetic material and is resistant to oxygen diffusion.

20. Roof system as claimed in any one of the preceding Claims, **characterised in that** at least one of the channels (13.1, 13.2) through which air flows is covered at least partly by a self-adhesive film web (30) which is sealed with respect to liquid.

21. Roof system as claimed in any one of the preceding Claims, **characterised in that** the supporting hollow profile (11) is divided into two chambers (86, 87) by an inner partition wall (85).

22. Roof system as claimed in any one of the preceding Claims, **characterised in that** guide elements (41) for the insertion of cartridges (7) are disposed beneath the supporting hollow profile.

23. Roof system as claimed in Claim 22, **characterised in that** the guide elements (41) are L-shaped profiles.

24. Roof system as claimed in any one of the preceding Claims, **characterised in that** a purlin (62) is disposed between the enclosed vacuum insulation panel (23) and the channels.

25. Roof system as claimed in any one of the preceding Claims, **characterised in that** the prefabricated roof module comprises at least one section (46) of a collecting channel (48) extending transversely with respect to the channels.

26. Roof system as claimed in any one of the preceding Claims, **characterised in that** a water pipe system extends between the supporting structures and a roof covering (1, 17) of the outer shell (50), the pipes of the water pipe system being disposed within roof battens (65).

27. Roof system as claimed in Claim 26, **characterised in that** the roof battens (65) are closed hollow profiles whose hollow spaces are in contact with the remaining hollow spaces of the supporting structures.

28. Roof system as claimed in Claim 26, **characterised in that** the pipes of the water pipe system extend within wooden roof battens (65) which have U- or V-shaped troughs incorporated therein.

29. Roof system as claimed in Claim 26, **characterised in that** the roof battens (65) are metal U-shaped profiles (92), and **in that** pipe sections (76) which extend in parallel with the eaves are disposed within the roof battens.

30. Roof system as claimed in any one of the preceding Claims, **characterised in that** the channels (12.1, 12.2, 12.3; 13.1, 13.2, 65, 76, 92) are connected to at least one circulating air or water system.

31. Roof system as claimed in any one of the preceding Claims, **characterised in that** the channels (13.1, 13.2) through which air flows are disposed between solid profiles (73).

32. Roof system as claimed in Claim 1, **characterised in that** the outer shell (50) is releasably connected to the supporting structures via a release-adhesive layer (56).

33. Roof system as claimed in Claim 1, **characterised in that** photovoltaic solar cells or modules (18; 28) are adhered to the outer shell (50) via removable release-adhesive strips (32).

## Revendications

1. Système modulaire (100) de toit isolé thermiquement comprenant au moins un module préfabriqué (10) de toit qui inclut au moins un canal d'écoulement (12.1, 12.2, 12.3; 13.1, 13.2; 5; 15.1, 15.2) pour un milieu fluidique et des structures porteuses sous lesquelles est placée, sur le côté opposé à l'entrée du rayonnement solaire, une coquille interne plane (60) composée d'au moins un panneau enveloppé (23) d'isolation par le vide en forme de plaque d'où l'air a été évacué, qui forme une couche d'isolation thermique (3), **caractérisé en ce que**
- le panneau (23) d'isolation par le vide est complètement enfermé par une enveloppe protectrice additionnelle (24);
- chaque module préfabriqué de toit comprend au moins deux profilés creux (11; 38; 42; 44) à tracé en arbalétrier qui forment les structures porteuses recevant une charge;
- chacun des profilés creux (11; 38; 42; 44) est un canal où peut s'écouler de l'eau ou de l'air;
- et **en ce qu'**au moins un élément de réglage (68) qui permet de réguler la section transversale d'aération est disposé à l'intérieur d'au moins un canal d'écoulement d'air.

2. Système de toit selon la revendication 1, **caractérisé en ce que** le même canal (12 .1, 12.2, 12.3; 13.1, 13.2) peut être commuté pour être traversé par un écoulement d'eau ou d'air.

3. Système de toit selon la revendication 1 ou 2, **caractérisé en ce que** l'écoulement traversant les canaux (12.1, 12.2, 12.3; 13.1, 13.2) peut être régulé en fonction de la température, par divers caloporteurs en alternance, sous l'effet de récepteurs thermiques (40) du module préfabriqué (10) de toit intégrés dans une coquille externe (50).

4. Système de toit selon la revendication 3, **caractérisé en ce que** des récepteurs thermiques (40) qui sont eux-mêmes connectés, par des circuits ou sans fil, dans un système de mesure et de régulation côté bâtiment sont intégrés dans la coquille externe (50) du module préfabriqué (10) de toit.

5. Système de toit selon la revendication 1, **caractérisé en ce que** les largeurs des canaux (12.1, 12.2, 12.3; 13.1, 13.2) sont différentes.

6. Système de toit selon la revendication 1, **caractérisé en ce que** l'enveloppe protectrice (24) est une cassette (7).

7. Système de toit selon la revendication 6, **caractérisé en ce que** la cassette (7) est en métal.

8. Système de toit selon la revendication 7, **caractérisé en ce que** la cassette (7) est fabriquée en tôle d'acier inoxydable.

9. Système de toit selon la revendication 6, **caractérisé en ce que** la cassette (7) est en matière plastique.

10. Système de toit selon la revendication 6, **caractérisé en ce que** la cassette (7) est en carton revêtu ou imprégné de résine ou de cire.

11. Système de toit selon la revendication 6, **caractérisé en ce que** la cassette (7) est en matériau dérivé du bois.

12. Système de toit selon la revendication 6, **caractérisé en ce que** la cassette (7) est en verre.

13. Système de toit selon la revendication 1, **caractérisé en ce que** l'enveloppe protectrice (24) est produite par dépôt de mousse autour du panneau (23) d'isolation par le vide.

14. Système de toit selon l'une quelconque des revendications précédentes, **caractérisé en ce que** les profilés porteurs creux sont entourés par la cassette (7).

15. Système de toit selon l'une quelconque des revendications précédentes, **caractérisé en ce que** la cassette (7) comporte des éléments de fixation pour la connecter au profilé creux porteur par effet de force, en engagement positif ou par une matière.

16. Système de toit selon la revendication 15, **caractérisé en ce que** les éléments de fixation sont des chevilles thermo-isolantes (33).

17. Système de toit selon l'une quelconque des revendications précédentes, **caractérisé en ce que** les cassettes (7) peuvent être fixées sur les structures porteuses par des connexions embrochables libérables.

18. Système de toit selon la revendication 16, **caractérisé en ce que** le connecteur embrochable comprend une nervure (25) en forme de clip où sont ménagées de multiples ouvertures (69) dans lesquelles des boutons d'encliquetage (70, 71) connectés eux-mêmes à la cassette (7) s'enclenchent élastiquement.

19. Système de toit selon l'une quelconque des revendications précédentes, **caractérisé en ce que** le canal (5; 12.1, 12.2, 12.3; 13.1, 13.2; 14.1, 14.2; 15.1; 15.2; 65; 76) comporte une surface interne (29) revêtue de matière plastique et étanche à la diffusion d'oxygène.

20. Système de toit selon l'une quelconque des revendications précédentes, **caractérisé en ce qu'**au moins l'un des canaux d'écoulement d'air (13.1, 13.2) est au moins partiellement revêtu d'une bande pelliculaire auto-adhésive (30) étanche aux fluides.

21. Système de toit selon l'une quelconque des revendications précédentes, **caractérisé en ce que** le profilé creux porteur (11) est divisé en deux chambres (86, 87) par une paroi intermédiaire interne (85).

22. Système de toit selon l'une quelconque des revendications précédentes, **caractérisé en ce que** des éléments de guidage (41) sont disposés au dessous du profilé creux porteur pour y emboîter des cassettes (7).

23. Système de toit selon la revendication 22, **caractérisé en ce que** les éléments de guidage (41) sont des profilés en L.

24. Système de toit selon l'une quelconque des revendications précédentes, **caractérisé en ce qu'**une panne (62) est disposée entre les canaux et la panneau enveloppé (23) d'isolation par le vide.

25. Système de toit selon l'une quelconque des revendications précédentes, **caractérisé en ce que** le module préfabriqué de toit
comprend au moins un segment (46) d'un canal collecteur (48) de tracé perpendiculaire aux canaux.

26. Système de toit selon l'une quelconque des revendications précédentes, **caractérisé en ce qu'**un système de tubes d'eau dont les tubes sont disposés à l'intérieur de lattes (65) du toit passe entre les structures porteuses et une couverture (1, 17) de toit de la coquille externe (50).

27. Système de toit selon la revendication 26, **caractérisé en ce que** les lattes (65) du toit sont des profilés creux fermés dont les espaces creux sont en contact avec les autres espaces creux des structures porteuses.

28. Système de toit selon la revendication 26, **caractérisé en ce que** les tubes du système de tubes d'eau courent à l'intérieur de lattes (65) de toit en bois dans lesquelles sont ménagées des cavités en U ou en V.

29. Système de toit selon la revendication 26, **caractérisé en ce que** les lattes (65) de toit sont des profilés métalliques en U (92) et **en ce que** des segments (76) de tubes de tracé parallèle à la gouttière sont disposés à l'intérieur des lattes du toit.

30. Système de toit selon l'une quelconque des revendications précédentes, **caractérisé en ce que** les canaux (12.1, 12.2, 12.3; 13.1, 13.2; 14.1, 14.2; 15.1; 15.2; 65; 76; 92) sont raccordés à au moins un système de circulation d'air ou d'eau.

31. Système de toit selon l'une quelconque des revendications précédentes, **caractérisé en ce que** les canaux (13.1, 13.2) d'écoulement d'air sont disposés entre des profilés massifs (73).

32. Système de toit selon la revendication 1, **caractérisé en ce que** la coquille externe (50) est connectée de façon détachable aux structures porteuses par une couche (56) d'adhésif décollable.

33. Système de toit selon la revendication 1, **caractérisé en ce que** des cellules ou des modules solaires photovoltaïques (18; 28) sont collés sur la coquille externe (50) par des bandes adhésives décollables détachables (32).
